(19) **Europäisches Patentamt / European Patent Office / Office européen des brevets**

(11) **EP 4 667 954 A1**

(12) **EUROPEAN PATENT APPLICATION**
published in accordance with Art. 153(4) EPC

(43) Date of publication:
24.12.2025 Bulletin 2025/52

(21) Application number: 24894418.3

(22) Date of filing: 29.10.2024

(51) International Patent Classification (IPC):
$G01R\ 31/367^{(2019.01)}$    $G01R\ 31/374^{(2019.01)}$
$G01R\ 31/3842^{(2019.01)}$    $G01R\ 31/396^{(2019.01)}$
$G01R\ 19/165^{(2006.01)}$    $G01R\ 19/10^{(2006.01)}$
$G01R\ 19/00^{(2006.01)}$    $G06N\ 20/00^{(2019.01)}$
$B60L\ 58/12^{(2019.01)}$

(52) Cooperative Patent Classification (CPC):
B60L 58/12; G01R 19/00; G01R 19/10;
G01R 19/165; G01R 31/367; G01R 31/374;
G01R 31/3842; G01R 31/396; G06N 20/00;
H01M 10/052; Y02E 60/10

(86) International application number:
PCT/KR2024/016664

(87) International publication number:
WO 2025/110524 (30.05.2025 Gazette 2025/22)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 24.11.2023 KR 20230165462

(71) Applicant: LG Energy Solution, Ltd.
Seoul 07335 (KR)

(72) Inventors:
• YOON, Seo-Young
  Daejeon 34122 (KR)
• CHOI, Soon-Hyung
  Daejeon 34122 (KR)
• KIM, Young-Deok
  Daejeon 34122 (KR)

(74) Representative: Goddar, Heinz J.
Boehmert & Boehmert
Anwaltspartnerschaft mbB
Pettenkoferstrasse 22
80336 München (DE)

(54) **BATTERY DIAGNOSIS APPARATUS AND BATTERY DIAGNOSIS METHOD**

(57) Provided is a battery diagnosis apparatus and a battery diagnosis method. The battery diagnosis apparatus includes a data obtaining unit configured to obtain a first target full-cell profile representing a correspondence between a capacity factor and a voltage of a target cell while a first electric stimulation is being applied to the target cell, and a control circuit configured to generate an estimated full-cell profile based on the first target full-cell profile and an overpotential profile. The control circuit determines a first performance factor group as a primary estimation result for charge/discharge performance of the target cell by applying a cell diagnosis logic to the estimated full-cell profile. The control circuit determines a second performance factor group as a secondary estimation result for the charge/discharge performance of the target cell by applying a factor correction model to the first performance factor group. The second performance factor group includes an estimation result of a positive electrode participation end point of the target cell.

FIG 1

**Description**

TECHNICAL FIELD

The present disclosure relates to a battery diagnosis apparatus and method for non-destructively diagnosing the charge/discharge performance of a battery.

The present application claims priority to Korean Patent Application No. 10-2023-0165462 filed on November 24, 2023, in the Republic of Korea, the disclosures of which are incorporated herein by reference.

BACKGROUND ART

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be repeatedly recharged.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

In general, the actual charge/discharge performance of a battery may fall short of the normal charge/discharge performance due to reasons such as manufacturing defects or deterioration due to use, and it is necessary to accurately diagnose the charge/discharge performance of the battery in order to improve the life and safety of the battery.

Conventionally, while a low electric stimulation (e.g., low-rate charge or discharge) is being applied to the battery, the voltage and capacity of the battery are measured and recorded, and a full-cell profile representing the correspondence between the voltage and capacity is generated based on the recorded measurement values to diagnose the state of the battery. However, since the capacity and voltage of the battery change slowly while a low electric stimulation (e.g., low-rate charge or discharge) is being applied, there is a limitation in that it takes a long time to diagnose the battery.

In terms of shortening the diagnosis time, high electric stimulation is naturally more advantageous than low electric stimulation. However, when high electric stimulation (e.g., high-rate charge or discharge) is being applied to the battery, the proportion of overpotential in the battery voltage is excessively high. More specifically, as the current flowing through the battery is greater, the polarization phenomenon is generated more, and overpotential is caused by the polarization phenomenon. Since the voltage of the battery may be viewed as the sum of OCV (Open Circuit Voltage) and overpotential, as the level of electric stimulation applied to the battery is higher, the difference between the battery voltage and the actual OCV increases.

As the voltage of the battery is closer to the actual OCV, the charge/discharge performance of the battery may be diagnosed more accurately, so overpotential acts as a kind of noise that reduces the diagnostic accuracy. Therefore, the diagnosis result of charge/discharge performance based on the full-cell profile obtained using high electric stimulation may have a significant gap with the actual charge/discharge performance of the battery.

DISCLOSURE

Technical Problem

The present disclosure is designed to solve the problems of the related art, and therefore the present disclosure is directed to providing a battery diagnosis apparatus and battery diagnosis method that may simultaneously shorten the diagnosis time and secure diagnosis accuracy simultaneously by applying a high electric stimulation to a battery to obtaining charge/discharge information ('first target full-cell profile' of the claims) and removing noise caused by overpotential included in the obtained charge/discharge information using a machine learning-based factor correction model.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

In one aspect of the present disclosure, there is provided a battery diagnosis apparatus comprising: a data obtaining unit configured to obtain a first target full-cell profile representing a correspondence between a capacity factor and a voltage of a target cell while a first electric stimulation is being applied to the target cell, which is a battery cell to be diagnosed; and a control circuit configured to generate an estimated full-cell profile based on the first target full-cell profile and an overpotential profile. The control circuit is configured to determine a first performance factor group as a primary estimation result for charge/discharge performance of the target cell by applying a cell diagnosis logic to the estimated full-cell profile, and determine a second performance factor group as a secondary estimation result for the charge/discharge performance of the target cell by applying a factor correction model to the first performance factor group. The second performance factor group includes an estimation result of a positive electrode participation end point of the target cell, which is determinable by applying the cell diagnosis logic to a second target full-cell profile representing a correspondence between the capacity factor and the voltage of the target cell while a second electric stimulation, which is different from the first electric stimulation, is being applied.

The first electric stimulation may be an electric stimulation that induces an overpotential exceeding an allowable level in the target cell, and the second electric stimulation may be an electric stimulation that induces an overpotential less than the allowable level in the target cell.

The first electric stimulation may be charging using a first current rate, and the second electric stimulation may be charging using a second current rate, which is less than the first current rate.

The first electric stimulation may be discharge using a first current rate, and the second electric stimulation may be discharge using a second current rate, which is less than the first current rate.

The overpotential profile may represents a difference between a first reference full-cell profile and a second reference full-cell profile. The first reference full-cell profile may represent a correspondence between a capacity factor and a voltage of a reference cell while the first electric stimulation is being applied to the reference cell, which is a battery cell that is verified as normal. The second reference full-cell profile may represent a correspondence between the capacity factor and the voltage of the reference cell while the second electric stimulation is being applied to the reference cell.

The control circuit may be configured to generate the estimated full-cell profile by subtracting the overpotential profile from the first target full-cell profile.

The first performance factor group may include at least one of followings as a performance factor: a positive electrode participation start point representing a positive electrode voltage and a positive electrode capacity when the voltage of the target cell matches a first set voltage; a positive electrode participation end point representing a positive electrode voltage and a positive electrode capacity when the voltage of the target cell matches a second set voltage; a positive electrode scaling factor representing a ratio of capacity differences of the positive electrode participation start point and the positive electrode participation end point with respect to a reference positive electrode capacity; a negative electrode participation start point representing a negative electrode voltage and a negative electrode capacity when the voltage of the target cell matches the first set voltage; a negative electrode participation end point representing a negative electrode voltage and a negative electrode capacity when the voltage of the target cell matches the second set voltage; and a negative electrode scaling factor representing a ratio of capacity differences of the negative electrode participation start point and the negative electrode participation end point with respect to a reference negative electrode capacity.

The factor correction model may be a machine learning model trained by a training data set that includes a pair of first performance factor group and second performance factor group of each of a plurality of test cells with different charge/discharge performances.

The first performance factor group of each of the plurality of test cells may be obtained by applying the cell diagnosis logic to each of a plurality of estimated test full-cell profiles. The plurality of estimated test full-cell profiles may be obtained by subtracting the overpotential profile from each of a plurality of primary test full-cell profiles representing a correspondence between the capacity factor and the voltage of each of the plurality of test cells while the first electric stimulation is being applied to each of the plurality of test cells. The second performance factor group of each of the plurality of test cells may be obtained by applying the cell diagnosis logic to a plurality of secondary test full-cell profiles. The plurality of secondary test full-cell profiles may represent a correspondence between the capacity factor and the voltage of each of the plurality of test cells while the second electric stimulation is being applied to each to the plurality of test cells.

In another aspect of the present disclosure, there is also provided a battery pack, comprising the battery diagnosis apparatus.

In still another aspect of the present disclosure, there is also provided an electric vehicle, comprising the battery pack.

In still another aspect of the present disclosure, there is also provided a battery diagnosis method, comprising: obtaining a first target full-cell profile representing a correspondence between a capacity factor and a voltage of a target cell while a first electric stimulation is being applied to the target cell, which is a battery cell to be diagnosed; generating an estimated full-cell profile based on the first target full-cell profile and an overpotential profile; determining a first performance factor group as a primary estimation result for charge/discharge performance of the target cell by applying a cell diagnosis logic to the estimated full-cell profile; and determining a second performance factor group as a secondary estimation result for the charge/discharge performance of the target cell by applying a factor correction model to the first performance factor group. The second performance factor group may include an estimation result of a positive electrode participation end point of the target cell, which is determinable by applying the cell diagnosis logic to a second target full-cell profile instead of the estimated full-cell profile, wherein the second target full-cell profile represents a correspondence between the capacity factor and the voltage of the target cell while a second electric stimulation, which is different from the first electric stimulation, is being applied.

The step of generating an estimated full-cell profile may be generating the estimated full-cell profile by subtracting the overpotential profile from the first target full-cell profile.

The factor correction model may be a machine learning model trained by a training data set that includes a pair of first performance factor group and second performance factor group of each of a plurality of test cells with different charge/discharge performances.

The first performance factor group of each of the plurality of test cells may be obtained by applying the cell diagnosis logic to each of a plurality of estimated test full-cell profiles. The plurality of estimated test full-cell profiles may be obtained by subtracting the overpotential profile from each of a plurality of primary test full-cell profiles representing a correspondence between the capacity factor and the voltage of each of the plurality of test cells while the first electric stimulation is being applied to each of the plurality of test cells. The second performance factor group of each of the plurality of test cells may be obtained by applying the cell diagnosis logic to a plurality of secondary test full-cell profiles. The plurality of secondary test full-cell profiles may represent a correspondence between the capacity factor and the voltage of each of the plurality of test cells while the second electric stimulation is being applied to each to the plurality of test cells.

Advantageous Effects

According to at least one of the embodiments of the present disclosure, the charge/discharge performance of the battery may be diagnosed from charge/discharge information ('first target full-cell profile' of the claims) obtained by applying a high electric stimulation to the battery. Therefore, the time required for diagnosing the charge/discharge performance of the battery may be shortened compared to a diagnosis method using a low electric stimulation (e.g., low rate charge or discharge).

In addition, according to at least one of the embodiments of the present disclosure, by estimating charge/-discharge information ('estimated full-cell profile' of the claims) from which an overpotential component caused by a high electric stimulation is removed from the charge/discharge information obtained by applying a high electric stimulation to the battery and analyzing the estimated charge/discharge information to diagnose the charge/discharge performance, the accuracy of the diagnosis of the charge/discharge performance may be improved.

In addition, according to at least one of the embodiments of the present disclosure, by correcting a performance factor group representing the charge/discharge performance determined from the estimated charge/discharge information using a machine learning-based factor correction model, a diagnosis result having a high degree of consistency with the actual charge/discharge performance of the battery may be secured.

The effects of the present disclosure are not limited to the effects mentioned above, and these and other effects will be clearly understood by those skilled in the art from the appended claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a drawing exemplarily showing the configuration of an electric vehicle according to the present disclosure.
FIG. 2 is a drawing referenced for explaining the relationship between an electric stimulation and a full-cell profile.
FIG. 3 is a drawing schematically showing an overpotential profile that may be obtained from a first reference full-cell profile and a second reference full-cell profile of FIG. 2.
FIG. 4 is a graph referenced for explaining the relationship between a first target full-cell profile, an estimated full-cell profile, and a second target full-cell profile.
FIG. 5 is a graph referenced for explaining an example of each of the estimated full-cell profile, the second reference full-cell profile, the reference positive electrode profile, and the reference negative electrode profile.
FIGS. 6 to 8 are drawings referenced for explaining an example of a procedure for generating a comparison full-cell profile according to a cell diagnosis logic.
FIGS. 9 to 11 are drawings referenced for explaining another example of the procedure for generating a comparison full-cell profile according to a cell diagnosis logic.
FIG. 12 is a drawing referenced for explaining the function of a factor correction model.
FIG. 13 is a drawing referenced for explaining a training data set provided for training the factor correction model.
FIG. 14 is a diagram showing an example of a neural network structure of the factor correction model of FIG. 12.
FIG. 15 is a diagram showing an example of a correlation coefficient between performance factors obtained through training the factor correction model.

FIG. 16 is a flowchart for schematically illustrating a battery diagnosis method according to another embodiment of the present disclosure.

## BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

The terms including the ordinal number such as "first", "second" and the like, are used to distinguish one element from another among various elements, but not intended to limit the elements by the terms.

Unless the context clearly indicates otherwise, the terms "comprise" and "include" when used in this specification, specify the presence of stated elements, but do not preclude the presence or addition of one or more other elements. Additionally, the term "... unit" as used herein refers to a processing unit of at least one function or operation, and may be implemented by hardware and software either alone or in combination.

In addition, throughout the specification, it will be further understood that when an element is referred to as being "connected to" another element, it can be directly connected to the other element or intervening elements may be present.

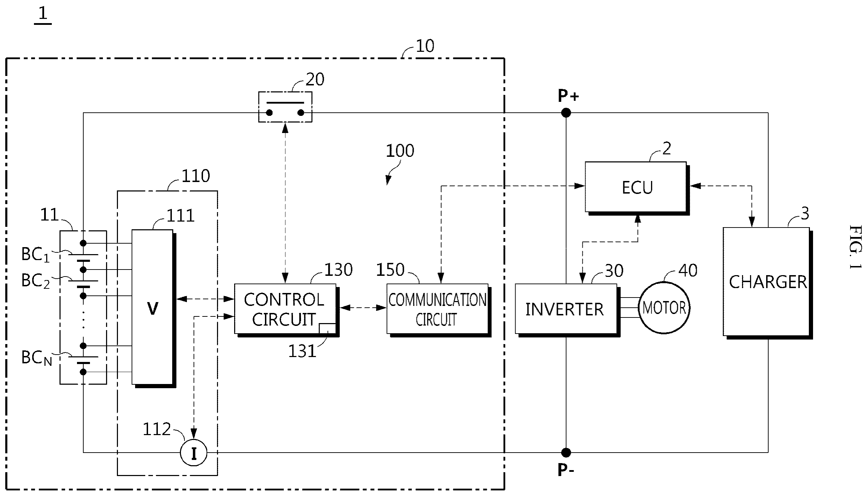

FIG. 1 is a drawing exemplarily showing the configuration of an electric vehicle according to the present disclosure.

Referring to FIG. 1, the electric vehicle 1 includes a vehicle controller 2, a battery pack 10, a relay 20, an inverter 30, and an electric motor 40.

Charging and discharging terminals P+ and P- of the battery pack 10 may be electrically connected to an inverter 30 and/or a charger 3 through a charging cable or the like. The charger 3 may be included in an electric vehicle 1 or may be provided at a charging station.

The vehicle controller 2 (e.g., ECU: Electronic Control Unit) is configured to transmit a key-on signal to the battery diagnosis apparatus 100 in response to that a start button (not shown) provided in the electric vehicle 1 is switched to an ON position by a user. The vehicle controller 2 is configured to transmit a key-off signal to the battery diagnosis apparatus 100 in response to that the start button is switched to an OFF position by the user. The charger 3 may communicate with the vehicle controller 2 and supply a charging power in a constant current charging mode, a constant voltage charging mode and/or a constant power charging mode to the battery 11 through the charging and discharging terminals P+ and P- of the battery pack 10.

The battery pack 10 includes battery 11. The battery pack 10 may further include the battery diagnosis apparatus 100.

The battery 11 includes at least one battery cell BC. When the battery 11 includes a plurality of battery cells ($BC_1$ to $BC_N$, N is a natural number greater than or equal to 2), the plurality of battery cells may be connected in series, in parallel, or in a mixture of series and parallel.

The type of the battery cell BC is not particularly limited, as long as it is capable of repeated charging and discharging, such as a lithium ion cell. The battery cell BC may include at least one unit cell. The unit cell is an electrochemical device that may be recharged independently. When the battery cell BC includes a plurality of unit cells, the plurality of unit cells may be connected in series, in parallel, or in a mixture of series and parallel. The battery cell BC may be a new battery cell that requires verification as to whether it is a good product, or a battery cell that has deteriorated after being verified as a good product and is no longer a new product. Hereinafter, the battery cell BC may be referred to as a 'target battery cell' or a 'target cell.'

The relay 20 is electrically connected in series to the battery 11 through a power path that connecting the battery 11 and the inverter 30. In FIG. 1, the relay 20 is illustrated as connected between the positive electrode terminal of the battery 11 and the charging and discharging terminal P+. The relay 20 is controlled to turn on and off in response to a switching signal from the battery diagnosis apparatus 100. The relay 20 may be a mechanical contactor turned on and off by the magnetic force of a coil, or a semiconductor switch such as a MOSFET (Metal Oxide Semiconductor Field Effect transistor).

The inverter 30 is provided to convert DC current from the battery 11 into AC current in response to a command from the battery diagnosis apparatus 100 or the vehicle controller 2.

The electric motor 40 is driven using AC current power from the inverter 30. As the electric motor 40, for example, a three-phase AC current motor 40 may be used.

The battery diagnosis apparatus 100 includes a control circuit 130 and a memory 131. The battery diagnosis apparatus 100 may further include at least one of a sensing unit 110 and a communication circuit 150. The data obtaining unit recited in the claims of this application includes at least one of the sensing unit 110 and the communication circuit 150.

The sensing unit 110 includes a voltage sensor 111 and a current sensor 112.

The voltage sensor 111 is connected in parallel to the battery 11, measures the battery voltage, which is the voltage across both terminals of the battery 11, and is configured to generate a voltage signal representing the measured battery voltage.

Of course, the voltage sensor 111 may be connected to the positive electrode terminal and the negative electrode terminal of each battery cell BC included in the battery 11, measure the cell voltage (which may be referred to as the 'full-cell voltage') which is the voltage across both terminals of each battery cell BC, and output an additional voltage signal representing the measured cell voltage (i.e., a measurement value of the full-cell voltage) to the control circuit 130.

The current sensor 112 is connected in series to the battery 11 through a current path between the battery 11 and the inverter 30. The current sensor 112 is configured to detect the battery current, which is a current flowing through the battery 11, and generate a current signal representing the detected battery current. The current sensor 112 may be implemented as one or a combination of two or more of known current detection elements such as a shunt resistor, a Hall effect element, etc.

The communication circuit 150 is configured to support wired or wireless communication between the control circuit 130 and the vehicle controller 2. The wired communication may be, for example, CAN (Controller Area Network) communication, and the wireless communication may be, for example, ZigBee or Bluetooth communication. The type of communication protocol is not particularly limited as long as it supports wired and wireless communication between the control circuit 130 and the vehicle controller 2. The communication circuit 150 may include an output device (e.g., a display, a speaker) that provides information received from the control circuit 130 and/or the vehicle controller 2 in a form recognizable to the user.

The control circuit 130 is operably coupled to the relay 20, the voltage sensor 111, the current sensor 112 and the communication circuit 150. The operable coupling of two components means that the two components are connected directly or indirectly to enable transmission and reception of signals in one direction or two directions.

The control circuit 130 may collect the voltage signal from the voltage sensor 111 and/or the current signal from the current sensor 112. The control circuit 130 may convert each analog signal collected from the sensors 111 and 112 into a digital value using an ADC (Analog to Digital Converter) provided therein and record the digital value.

The control circuit 130 may be called a 'control unit' or a 'battery controller', and may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing the other functions.

The memory 131 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory 131 may store data and programs required for calculation operations by the control circuit 130. The memory 131 may store data representing the result of a calculation operation performed by the control circuit 130. Although the memory 131 is depicted in FIG. 1 as being physically independent from the control circuit 130, the memory 131 may be embedded within the control circuit 130.

The control circuit 130 may turn on the relay 20 in response to a key-on signal. The control circuit 130 may turn off the relay 20 in response to a key-off signal. The key-on signal is a signal that requests switching from the rest mode to the charging or discharging mode. The key-off signal is a signal that induces switching from the cycle state to the resting state. Alternatively, the vehicle controller 2 may be responsible for turning on/off the relay 20 instead of the control circuit 130.

If the relay 20 is turned on while the inverter 30 or the charger 3 is operating, the battery 11 enters the cycle state. Conversely, if the relay 20 is turned off or the inverter 30 and the charger 3 stops operating, the battery 11 enters the resting state.

The cycle state refers to a state in which the battery 11 is being charged/discharged, and the resting state refers to a state in which charging/discharging of the battery 11 is stopped. The fact that the battery 11 is in a cycle state or a resting state means that each battery cell BC included in the battery 11 is also in a cycle state or a resting state.

The control circuit 130 may determine a voltage detection value and a current detection value based on a voltage signal and a current signal while the battery cell BC is in a cycle state and/or a resting state, and then determine (estimate) a SOC (State Of Charge) of the battery cell BC based on the voltage detection value and/or the current detection value.

If the charger 3 is operating in a constant current charging mode, the current rate (also referred to as 'C-rate') of the charging current supplied to the battery cell BC is a known constant value. Thus, when estimating the SOC of the battery cell BC, the current value of the constant current output from the charger 3 may be used instead of the current detection value obtained using the current sensor 112.

SOC is the ratio of the remaining capacity to the fully charged capacity (maximum capacity) of the battery cell BC, and is usually processed in the range of 0 to 1 or 0 to 100%. Known methods such as ampere counting, OCV (Open Circuit Voltage)-SOC curve, and/or Kalman filter may be utilized to determine SOC.

The communication circuit 150 may obtain the first target full-cell profile from a separate computing device provided externally (e.g., an electric vehicle 1) via wired communication and/or wireless communication. Alternatively, the sensing unit 110 may directly generate the first target full-cell profile of the target cell BC based on a measurement signal including a current signal and a voltage signal of the target cell BC, which is a battery cell to be diagnosed. Alternatively, the control circuit 130 may collect a measurement signal including a current signal and a voltage signal of the target cell BC from the sensing unit 110, and then generate the first target full-cell profile of the target cell BC based on the collected measurement signals.

The first target full-cell profile may represent the correspondence between the capacity factor and the voltage of the target cell BC while the first electric stimulation is being applied to the target cell BC. The capacity factor may be the residual capacity or SOC (State Of Charge) of the target cell BC.

The first electric stimulation is an electric stimulation that induces an overpotential exceeding the allowable level in the target cell BC, and corresponds to a 'high electric stimulation'. The second electric stimulation is an electric stimulation that induces an overpotential less than the allowable level in the target cell BC, and corresponds to a 'low electric stimulation'. For example, the first electric stimulation may be a charge using the first current rate (e.g., 1.0 C), and the second electric stimulation may be a charge using the second current rate (e.g., 0.05 C) which is less than the first current rate. For another example, the first electric stimulation may be a discharge using the first current rate, and the second electric stimulation may be a discharge using the second current rate.

The first target full-cell profile may be a profile representing the correspondence between the full-cell voltage and the capacity of the target cell BC while being charged or discharged at a constant current over a given voltage range (e.g., 3.0 to 4.0 V) or a given SOC range (e.g., 0 to 100% SOC).

Hereinafter, before explaining the first target full-cell profile obtained using the target cell BC of the present disclosure, the first reference full-cell profile and the second reference full-cell profile will be explained first.

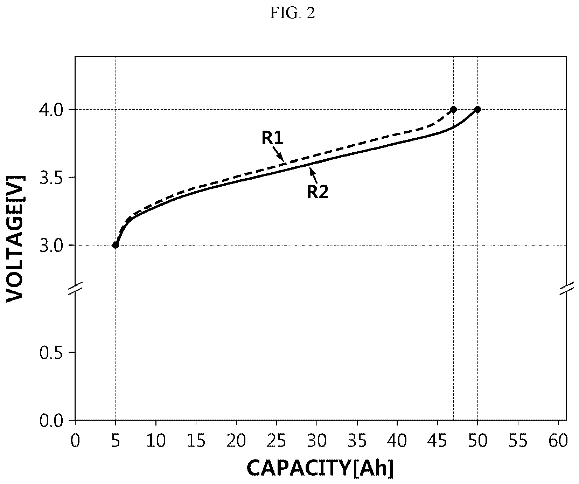

FIG. 2 is a drawing referenced for explaining the relationship between an electric stimulation and a full-cell profile.

The first reference full-cell profile R1 and the second reference full-cell profile R2 illustrated in FIG. 2 may be obtained in advance through a pre-experimental procedure of individually applying the first electric stimulation and the second electric stimulation to a reference battery cell.

The reference battery cell is a battery cell that has been verified as normal and may have the same level of positive electrode performance and negative electrode performance as a new battery cell that has been verified as a good product. The reference battery cell may be simply referred to as a 'reference cell'. The reference cell may be a coin-type cell that includes a positive electrode half-cell and a negative electrode half-cell, or a 3-electrode cell.

The new battery cell refers to a battery cell in a new state. The new state is the same concept as BOL (Beginning of Life). For example, it may be called BOL before the time when the cumulative charge/discharge capacity from the time of manufacturing completion reaches the set capacity, and it may be called MOL (Middle of Life) from the time when the cumulative charge/discharge capacity reaches the set capacity.

In the graph of FIG. 2, the horizontal axis (X-axis) represents capacity (Ah) and the vertical axis (Y-axis) represents voltage (V).

The first reference full-cell profile R1 illustrates the relationship between the capacity and voltage of the reference cell while the first electric stimulation is being applied (e.g., during charging using the first current rate). The second reference full-cell profile R2 illustrates the relationship between the capacity and voltage of the reference cell while the second electric stimulation is being applied (e.g., during charging using the second current rate). The first reference full-cell profile R1 may be obtained by performing charging using the first current rate in a state where the OCV of the reference cell is set equal to the lower limit (e.g., 3.0 V) of a given voltage range. The second reference full-cell profile R2 may be obtained by performing charging using the second current rate in a state where the OCV of the reference cell is set equal to the lower limit of a given voltage range. Therefore, in FIG. 2, the start points of the first reference full-cell profile R1 and the second reference full-cell profile R2 roughly coincide, whereas the end points are distinctly different.

The first reference full-cell profile R1 and the second reference full-cell profile R2 may represent the correspondence between the full-cell voltage and the capacity of the reference cell over at least the voltage range of interest (e.g., 3.0 to 4.0V). The lower and upper limits of the voltage range of interest may represent the first set voltage (3.0V in FIG. 2) and the second set voltage (4.0V in FIG. 2).

The SOC when the full-cell voltage of any battery cell is equal to the first set voltage may be set to 0%, and the SOC when the full-cell voltage is equal to the second set voltage may be set to 100%. That is, the first set voltage and the second set voltage may be lower and upper limits of the battery cell voltage corresponding to the SOC (State Of Charge) of 0% to 100% of any battery cell including the reference cell.

The start capacity (Qi) may refer to the residual capacity when the full-cell voltage of any battery cell is equal to the first set voltage. The end capacity (Qf) may refer to the residual capacity when the full-cell voltage of any battery cell is equal to the second set voltage.

The first reference full-cell profile R1 may be based on the voltage time series and current time series (or capacity time series) acquired by periodically measuring the full-cell voltage and current of the reference cell while the first electric stimulation is being applied.

The second reference full-cell profile R2 may be based on the voltage time series and current time series acquired by periodically measuring the full-cell voltage and current of the reference cell while the second electric stimulation is being applied.

Here, the first reference full-cell profile R1 may include overpotential in the voltage value corresponding to the same capacity value when compared with the second reference full-cell profile R2. Therefore, the voltage difference between the first reference full-cell profile R1 and the second reference full-cell profile R2 for the same capacity value may be calculated as overpotential.

Specifically, by removing the second reference full-cell profile R2 based on the second electric stimulation from the first reference full-cell profile R1 based on the first electric stimulation (calculating the voltage difference by capacity), an overpotential profile indicating overpotential by capacity may be generated.

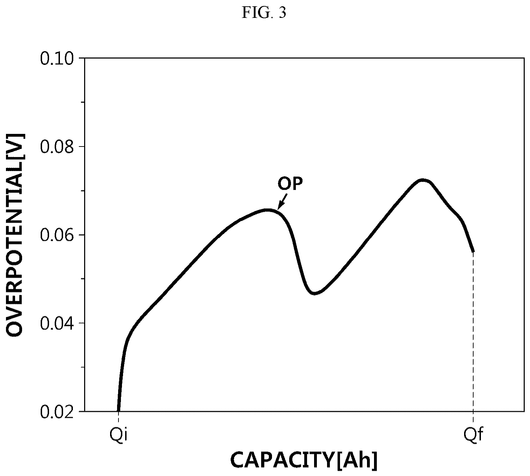

FIG. 3 is a drawing schematically showing an overpotential profile OP that may be obtained from a first reference full-cell profile R1 and a second reference full-cell profile R2 of FIG. 2.

The overpotential profile OP may be a profile representing the correspondence between capacity and overpotential. The overpotential profile OP may be a profile representing the voltage difference by capacity between the first reference full-cell profile R1 and the second reference full-cell profile R2.

The capacity range (Qi to Qf) of the overpotential profile OP may be a common capacity range between the first reference full-cell profile R1 and the second reference full-cell profile R2. In FIG. 2, the capacity range of the first reference full-cell profile R1 is 5 to 47 Ah, and the capacity range of the second reference full-cell profile R2 is 5 to 50 Ah, so Qi may be 5 Ah and Qf may be 47 Ah.

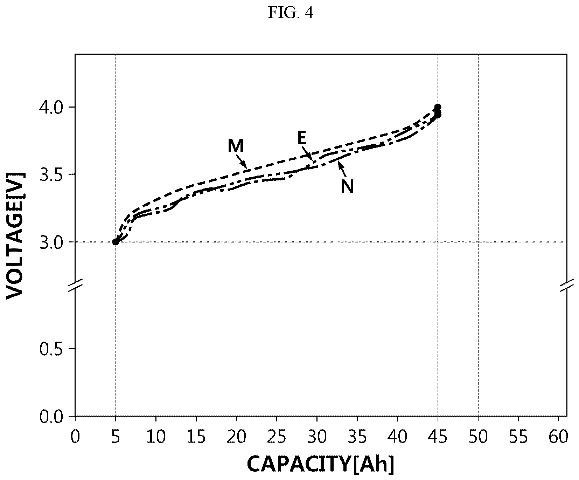

FIG. 4 is a graph referenced for explaining the relationship between a first target full-cell profile M, an estimated full-cell profile E, and a second target full-cell profile N.

In FIGS. 2 to 4, Ah is used as the unit of the horizontal axis, but this unit may be expressed in other forms. For example, instead of Ah, a percentage % indicating SOC (State Of Charge) may be used as the unit of the horizontal axis.

Referring to FIG. 4, the control circuit 130 may generate a first target full-cell profile M representing a correspondence between the capacity and the full-cell voltage of the target cell BC while the first electric stimulation is being applied to the target cell BC. The first target full-cell profile M may represent a correspondence between the full-cell voltage and the capacity of the target cell BC at least over a voltage range of interest.

Therefore, since the reference cell and the target cell BC have different charge/discharge performances, there is inevitably some difference between the first target full-cell profile M and the first reference full-cell profile R1.

For example, in the same voltage range of interest (e.g., 3.0 to 4.0 V), the capacity range of the first reference full-cell profile R1 shown in FIG. 2 is 5 to 47 Ah, whereas the capacity range of the first target full-cell profile M is 5 to 45 Ah.

The control circuit 130 may generate an estimated full-cell profile E based on the overpotential profile OP of FIG. 3 and the first target full-cell profile M of FIG. 4. Specifically, the control circuit 130 may generate the estimated full-cell profile E by subtracting the overpotential profile OP from the first target full-cell profile M. As a result, at the same capacity value, the voltage value of the estimated full-cell profile E may be less than the voltage value of the first target full-cell profile M.

The control circuit 130 may obtain the estimated full-cell profile E by subtracting the capacity-specific overpotential of the overpotential profile OP from the capacity-specific voltage of the first target full-cell profile M in the common capacity range of the first target full-cell profile M and the overpotential profile OP. In this case, the capacity range of 45 to 47 Ah among the entire capacity range of the overpotential profile OP may not be utilized. That is, the estimated full-cell profile E may be obtained by removing the capacity-specific overpotential of the overpotential profile OP corresponding to the capacity-specific voltage of the first target full-cell profile M.

Alternatively, the control circuit 130 may generate an adjusted overpotential profile (not shown in the drawing) by scaling the overpotential profile OP along the horizontal axis so that the capacity range of the overpotential profile OP matches the capacity range of the first target full-cell profile M. Subsequently, the control circuit 130 may generate an estimated full-cell profile E by subtracting the overpotential value of the adjusted overpotential profile from the voltage value of the first target full-cell profile M over the capacity range of the overpotential profile OP. That is, the estimated full-cell profile E may be obtained by removing the capacity-specific overpotential of the adjusted overpotential profile corresponding to the capacity-specific voltage of the first target full-cell profile M.

The second target full-cell profile N is an example of a profile representing the correspondence between the capacity factor and voltage of the target cell BC that would be expected to be obtained if the second electric stimulation was applied to the target cell BC instead of the first electric stimulation.

The estimated full-cell profile E is the estimation result of the second target full-cell profile N based on the first target full-cell profile M and the overpotential profile OP.

Referring to FIG. 4, the estimated full-cell profile E is a profile obtained by subtracting the overpotential profile OP from the first target full-cell profile M, and the estimated full-cell profile E is more similar to the second target full-cell profile N than the first target full-cell profile M. Therefore, in diagnosing the charge/discharge performance of the target cell BC, it is advantageous in terms of diagnostic accuracy to utilize the estimated full-cell profile E instead of the first target full-cell profile M.

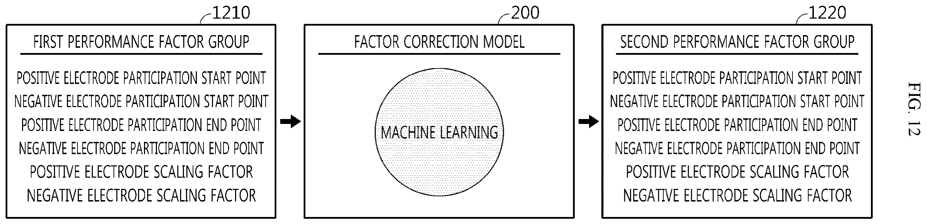

Meanwhile, since the estimated full-cell profile E does not completely match the second target full-cell profile N, there may still be a considerable difference between the diagnosis result of charge/discharge performance based on the estimated full-cell profile E and the actual charge/discharge performance. A method for reducing the error in the diagnosis result of charge/discharge performance will be described later with reference to FIG. 12.

The control circuit 130 may determine a first performance factor group representing the charge/discharge performance of the target cell BC by applying a cell diagnosis logic to the estimated full-cell profile E. The first performance factor group may be regarded as a primary estimation result for the charge/discharge performance of the target cell BC.

The first performance factor group may include a performance factor for at least one of a positive electrode participation start point, a positive electrode participation end point, a positive electrode scaling factor, a negative electrode participation start point, a negative electrode participation end point, and a negative electrode scaling factor.

In this specification, the positive electrode participation start point on the positive electrode profile of any battery cell represents the positive electrode voltage and the positive electrode capacity (or positive electrode SOC) when the full-cell voltage of the corresponding battery cell matches the first set voltage. The positive electrode voltage at the positive electrode participation start point may be called the 'positive electrode start potential'. Also, the negative electrode participation start point on the negative electrode profile of the corresponding battery cell indicates the negative electrode voltage and the negative electrode capacity (or negative electrode SOC) when the full-cell voltage of the corresponding battery cell matches the first set voltage. The negative electrode voltage at the negative electrode participation start point may be called the 'negative electrode start potential'. Therefore, the voltage difference between the positive electrode participation start point and the negative electrode participation start point may be equal to the first set voltage.

In addition, the positive electrode participation end point on the positive electrode profile of any battery cell indicates the positive electrode voltage and the positive electrode capacity when the full-cell voltage of the corresponding battery cell matches the second set voltage. The positive electrode voltage at the positive electrode participation end point may be called the 'positive electrode end potential'. Also, the negative electrode participation end point on the negative electrode profile of the corresponding battery cell indicates the negative electrode voltage and the negative electrode capacity when the full-cell voltage of the corresponding battery cell matches the second set voltage. The negative electrode voltage at the negative electrode participation end point may be called the 'negative electrode end potential'. Therefore, the voltage difference between the positive electrode participation end point and the negative electrode participation end point may be equal to the second set voltage.

In this specification, the positive electrode capacity (capacity value) at a specific point on the positive electrode profile of any battery cell may mean the capacity difference between any one of both end points of the positive electrode profile and the specific point. The positive electrode SOC at a specific point on the positive electrode profile of any battery cell may mean the ratio of the capacity difference between any one of both end points (e.g., low capacity point) of the positive electrode profile and the specific point to the capacity difference between two end points of the positive electrode profile.

Likewise, the negative electrode capacity (capacity value) at a specific point on the negative electrode profile of any battery cell may mean the capacity difference between any one of both end points of the negative electrode profile (or positive electrode profile) and the specific point. The negative electrode SOC at a specific point on the negative electrode profile of any battery cell may mean the ratio of the capacity difference between any one of both end points (e.g., low capacity point) of the negative electrode profile (or positive electrode profile) and the specific point to the capacity difference between both end points of the negative electrode profile.

The positive electrode scaling factor of any battery cell may represent the ratio of the capacity difference between the positive electrode participation start point and the positive electrode participation end point of the corresponding battery cell with respect to the reference positive electrode capacity of the reference cell. The negative electrode scaling factor of any battery cell may represent the ratio of the capacity difference between the negative electrode participation start point and the negative electrode participation end point of the corresponding battery cell with respect to the reference negative electrode capacity of the reference cell.

In the memory 131, information indicating the voltage and capacity of each of the reference positive electrode participation start point, the reference positive electrode participation end point, the reference negative electrode participation start point, and the reference negative electrode participation end point, which represent the charge/discharge performance of the reference cell, may be recorded in advance.

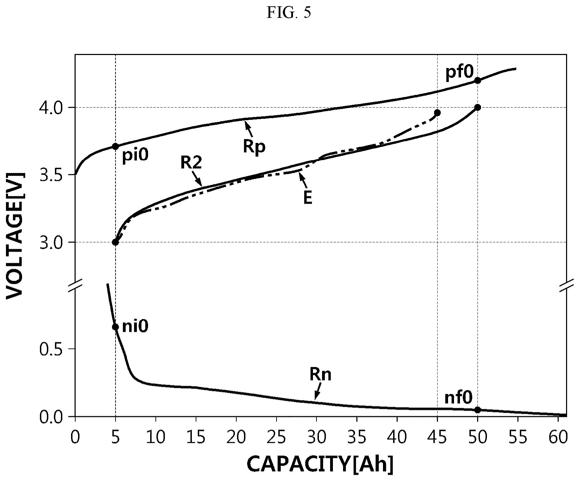

From now on, with reference to FIGS. 5 to 11, the diagnostic processes included in the cell diagnosis logic will be explained.

FIG. 5 is a graph referenced for explaining an example of each of the estimated full-cell profile E, the second reference full-cell profile R2, the reference positive electrode profile Rp, and the reference negative electrode profile Rn. In the graph of FIG. 5, the horizontal axis (X-axis) represents capacity and the vertical axis (Y-axis) represents voltage. The estimated full-cell profile E and the second reference full-cell profile R2 are the same as in FIG. 2.

Referring to FIG. 5, the reference positive electrode profile Rp may be a profile representing the correspondence between the positive electrode voltage and the capacity while the second electric stimulation is being applied to the reference cell. The positive electrode voltage of the reference cell refers to a potential difference between the potential of a reference electrode (not shown) and the potential of the positive electrode of the reference cell.

The reference negative electrode profile Rn may be a profile representing the correspondence between the negative electrode voltage and the capacity while the second electric stimulation is being applied to the reference cell. The negative electrode voltage of the reference cell refers to a potential difference between the potential of the reference electrode and the potential of the negative electrode of the reference cell.

The potential of the reference electrode may be, for example, the redox potential of lithium. The positive electrode voltage may be simply referred to as a positive electrode potential, and the negative electrode voltage can be simply referred to as a negative electrode potential.

The reference positive electrode profile Rp and the reference negative electrode profile Rn may be stored in advance in the memory 131.

At least one of the reference positive electrode profile Rp and the reference negative electrode profile Rn may be aligned along the horizontal axis so that the synthesis result of a part of the common capacity range (5 to 50 Ah in FIG. 5) of the reference positive electrode profile Rp and the reference negative electrode profile Rn matches the second reference full-cell profile R2.

FIG. 5 shows an example in which the reference negative electrode profile Rn is aligned to be shifted to the right based on the start point (point corresponding to capacity 0) of the reference positive electrode profile Rp.

It may be found from FIG. 5 that both ends of the reference positive electrode profile Rp and the reference negative electrode profile Rn are offset from each other. In other words, the capacity range of the reference positive electrode profile Rp and the capacity range of the reference negative electrode profile Rn do not match and may only partially overlap. Therefore, the second reference full-cell profile R2 may indicate the full-cell voltage of a reference cell in a part of the capacity range common to the reference positive electrode profile Rp and the reference negative electrode profile Rn.

The control circuit 130 may be configured to compare the estimated full-cell profile E with at least one comparison full-cell profile. The comparison full-cell profile may be a result of generating an adjusted positive electrode profile and an adjusted negative electrode profile by adjusting each of the reference positive electrode profile Rp and the reference negative electrode profile Rn stored in the memory 131, and then synthesizing (combining) the adjusted positive electrode profile and the adjusted negative electrode profile.

In other words, when the second reference full-cell profile R2 is the result of subtracting a part of the reference negative electrode profile Rn from a part of the reference positive electrode profile Rp, the comparison full-cell profile may be regarded as the result of subtracting a part of the adjusted negative electrode profile from a part of the adjusted positive electrode profile.

The control circuit 130 may generate at least one comparison full-cell profile by directly adjusting the reference positive electrode profile Rp and the reference negative electrode profile Rn. Alternatively, the at least one comparison full-cell profile may be secured in advance based on the reference positive electrode profile Rp and the reference negative electrode profile Rn and stored in the memory 131. In this case, the control circuit 130 may obtain the comparison full-cell profile by accessing the memory 131 and reading the comparison full-cell profile.

The control circuit 130 may generate a plurality of comparison full-cell profiles from the reference positive electrode profile Rp and the reference negative electrode profile Rn by repeating an adjustment procedure of adjusting each of the reference positive electrode profile Rp and the reference negative electrode profile Rn to several levels and then synthesizing them. The comparison full-cell profile may also be referred to as an 'adjusted reference full-cell profile'.

The control circuit 130 may specify any one comparison full-cell profile among the plurality of comparison full-cell profiles, which has a minimum error with respect to the estimated full-cell profile E. Then, the control circuit 130 may determine that the adjusted positive electrode profile and the adjusted negative electrode profile mapped to the specified comparison full-cell profile are the positive electrode profile and the negative electrode profile of the target cell BC.

In relation to this, various methods known at the time of filing of this application may be employed to determine the error between two profiles as a group of data points, each of which may be expressed in a two-dimensional coordinate system. For example, the integral or the RMSE (Root Mean Square Error) of the absolute value of the area between the two profiles may be used as the error between the two profiles.

According to this configuration of the present disclosure, various state information about the target cell BC may be obtained based on the finally determined adjusted positive electrode profile and adjusted negative electrode profile. The finally determined adjusted positive electrode profile and adjusted negative electrode profile may be mapped to any one comparison full-cell profile with the minimum error to the estimated full-cell profile E among the plurality of comparison full-cell profiles. In particular, the comparison full-cell profile by the finally determined adjusted positive electrode profile and adjusted negative electrode profile may be almost identical to the estimated full-cell profile E in shape, etc.

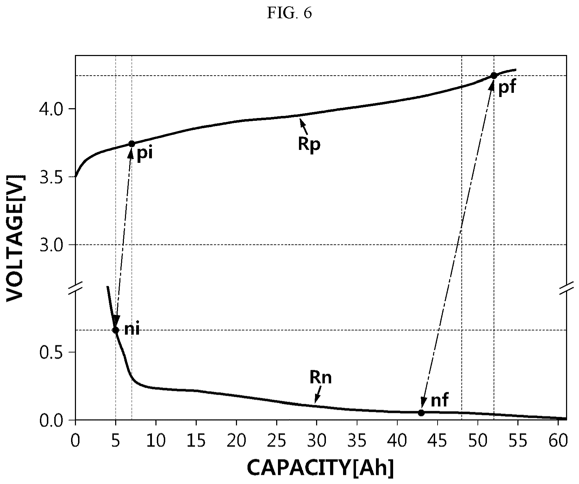

FIGS. 6 to 8 are diagrams referenced for explaining an example of a procedure for generating a comparison full-cell profile.

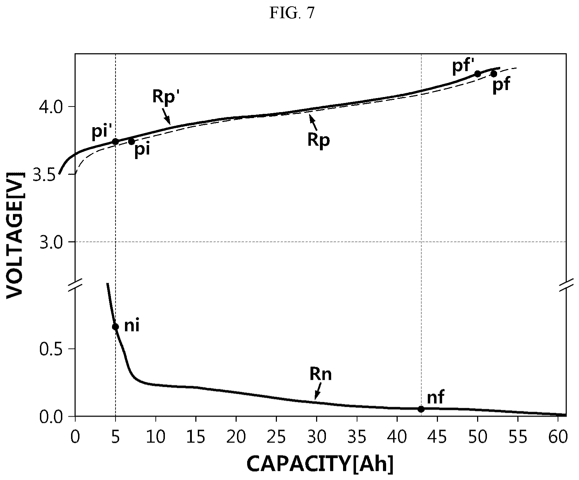

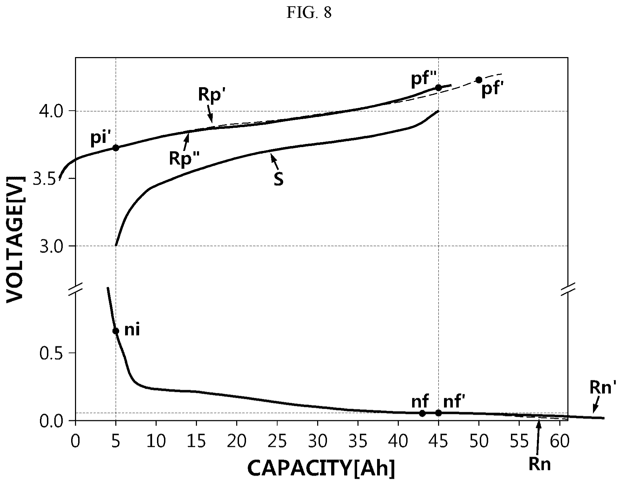

The procedure for generating a comparison full-cell profile, which will be explained with reference to FIGS. 6 to 8, may proceed in the order of a first routine for setting four points (positive electrode participation start point, positive electrode participation end point, negative electrode participation start point, negative electrode participation end point) to correspond to the voltage range of interest (see FIG. 6), a second routine for performing the profile shift (see FIG. 7), and a third routine for performing the capacity scaling (see FIG. 8). That is, the procedure for generating a comparison full-cell profile according to an embodiment of the present disclosure may include the first to third routines.

The reference positive electrode profile Rp and the reference negative electrode profile Rn shown in FIG. 6 are the same as those shown in FIG. 5.

The control circuit 130 may determine the positive electrode participation start point (pi), the positive electrode participation end point (pf), the negative electrode participation start point (ni) and the negative electrode participation end point (nf) on the reference positive electrode profile Rp and the reference negative electrode profile Rn.

Either the positive electrode participation start point (pi) or the negative electrode participation start point (ni) depends on the other.

As an example, the control circuit 130 may divide the positive electrode voltage range from the start point to the end point (or, second set voltage) of the reference positive electrode profile Rp into a plurality of small voltage sections, and then set a boundary point of two adjacent small voltage sections among the plurality of small voltage sections as a positive electrode participation start point (pi). Each small voltage section may have a predetermined size (e.g., 0.01V). Next, the control circuit 130 may set a point on the reference negative electrode profile Rn that is smaller than the positive electrode participation start point (pi) by the first set voltage (e.g., 3V) as a negative electrode participation start point (ni).

As another example, the control circuit 130 may divide the negative electrode voltage range from the start point to the end point of the reference negative electrode profile Rn into a plurality of small voltage sections of a predetermined size, and then set a boundary point of two adjacent small voltage sections among the plurality of small voltage sections as a negative electrode participation start point (ni). Next, the control circuit 130 may search for a point greater than the negative electrode participation start point (ni) by the first set voltage (e.g., 3V) from the reference positive electrode profile Rp and set the searched point as a positive electrode participation start point (pi).

Either the positive electrode participation end point (pf) or the negative electrode participation end point (nf) depends on the other.

As an example, the control circuit 130 may divide the voltage range from the second set voltage to the end point of the reference positive electrode profile Rp into a plurality of small voltage sections of a predetermined size, and then set a boundary point of two adjacent small voltage section among the plurality of small voltage sections as a positive electrode participation end point (pf). Next, the control circuit 130 may set a point on the reference negative electrode profile Rn that is smaller than the positive electrode participation end point (pf) by the second set voltage (e.g., 4V) as a negative electrode participation end point (nf).

As another example, the control circuit 130 may divide the negative electrode voltage range from the start point to the end point of the reference negative electrode profile Rn into plurality of small voltage sections of a predetermined size, and then set a boundary point of two adjacent small voltage sections among the plurality of small voltage sections as a negative electrode participation end point (nf). Next, the control circuit 130 may search for a point that is greater than the negative electrode participation end point (nf) by the second set voltage (e.g., 4V) from the reference positive electrode profile Rp and set the searched point as a positive electrode participation end point (pf).

If the positive electrode participation start point (pi), the positive electrode participation end point (pf), the negative electrode participation start point (ni), and the negative electrode participation end point (nf) are completely determined, the control circuit 130 shifts at least one of the reference positive electrode profile Rp and the reference negative electrode profile Rn to the left or right along the horizontal axis.

Referring to FIG. 6, the control circuit 130 may shift the reference positive electrode profile Rp to the left (toward low capacity) or shift the reference negative electrode profile Rn to the right (toward high capacity), or shift both of them, so that the capacity values of the positive electrode participation start point (pi) and the negative electrode participation start point (ni) match.

Alternatively, the control circuit 130 shifts the reference positive electrode profile Rp to the left or shift the reference negative electrode profile Rn to the right, or shift both of them, so that the capacity values of the positive electrode participation end point (pf) and the negative electrode participation end point (nf) match.

FIG. 7 illustrates a situation where only the reference positive electrode profile Rp is shifted to the left to generate an adjusted reference positive electrode profile (Rp'), and as a result, the capacity value of the positive electrode participation start point (pi') matches the capacity value of the negative electrode participation start point (ni). The adjusted reference positive electrode profile (Rp') may be the result of applying an adjustment procedure that shifts to the left by the capacity difference between the positive electrode participation start point (pi) and the negative electrode participation start point (ni) to the reference positive electrode profile Rp. Therefore, the two points (pi, pi') may be different only in capacity value and have the same voltage. Also, the two points (pf, pf') may be different only in the capacity value and have the same voltage.

If the adjustment result profiles (Rp', Rn) in which at least one of the reference positive electrode profile Rp and the reference negative electrode profile Rn is shifted are secured, the control circuit 130 may scale the capacity range of at least one of the adjustment result profiles (Rp', Rn).

According to the example shown in FIG. 7, the control circuit 130 may perform an additional adjustment procedure to shrink or expand at least one of the adjusted reference positive electrode profile (Rp') and the reference negative electrode profile Rn along the horizontal axis.

Referring to FIG. 8, the control circuit 130 may generate an adjusted reference positive electrode profile (Rp") by shrinking or expanding the adjusted reference positive electrode profile (Rp') so that the size of the capacity range between two points (pi', pf') of the adjusted reference positive electrode profile (Rp') matches the size of the capacity range of the estimated full-cell profile E. At this time, any one point (pi') of the two points (pi', pf') may be fixed. Accordingly, the capacity difference between the two points (pi', pf") of the adjusted reference positive electrode profile (Rp") may match the capacity range of the estimated full-cell profile E.

In addition, the control circuit 130 may generate an adjusted reference negative electrode profile (Rn') by shrinking or expanding the reference negative electrode profile Rn so that the size of the capacity range between two points (ni, nf) of the reference negative electrode profile Rn matches the size of the capacity range of the estimated full-cell profile E. At this time, any one point (ni) of the two points (ni, nf) may be fixed. Accordingly, the capacity difference between the two points (ni, nf') of the adjusted reference negative electrode profile (Rn') may match the capacity range of the estimated full-cell profile E.

In FIG. 8, the adjusted reference positive electrode profile (Rp") is the result of shrinking the adjusted reference positive electrode profile (Rp') shown in FIG. 7, and the adjusted reference negative electrode profile (Rn') is the result of expanding the reference negative electrode profile Rn shown in FIG. 7.

The positive electrode participation end point (pf") on the adjusted reference positive electrode profile (Rp") corresponds to the positive electrode participation end point (pf) on the adjusted reference positive electrode profile (Rp'). The negative electrode participation end point (nf') on the adjusted reference negative electrode profile (Rn') corresponds to the negative electrode participation end point (nf) on the reference negative electrode profile (Rn).

The capacity difference between the positive electrode participation start point (pi') and the positive electrode participation end point (pf") of the adjusted reference positive electrode profile (Rp") corresponds to the size of the capacity range of the estimated full-cell profile E. Likewise, the capacity difference between the negative electrode participation start point (ni) and the negative electrode participation end point (nf') of the adjusted reference negative electrode profile (Rn') corresponds to the size of the capacity range of the estimated full-cell profile E.

In addition, the capacity range by the two points (pi', pf") of the adjusted reference positive electrode profile (Rp") matches the capacity range by the two points (ni, nf') of the adjusted reference negative electrode profile (Rn'). The control circuit 130 may generate a comparison full-cell profile S by subtracting the portion between two points (pi, pf') of the adjusted reference positive electrode profile (Rp") from the portion between two points (ni, nf') of the adjusted reference negative electrode profile (Rn').

The control circuit 130 may calculate an error (profile error) between the comparison value between the comparison full-cell profile S and the estimated full-cell profile E.

The control circuit 130 may map at least two of the adjusted reference positive electrode profile (Rp"), the adjusted reference negative electrode profile (Rn'), the positive electrode participation start point (pi'), the positive electrode participation end point (pf"), the negative electrode participation start point (ni), the negative electrode participation end point (nf'), the positive electrode scaling factor, the negative electrode scaling factor, the comparison full-cell profile S, and the profile error with each other and record the same in the memory 131.

The positive electrode scaling factor of the adjusted reference positive electrode profile (Rp") may represent a ratio of the capacity difference between the two points (pi', pf") to the capacity difference between the two points (pi0, pf0). Alternatively, the positive electrode scaling factor of the adjusted reference positive electrode profile (Rp") may represent a ratio of the positive electrode capacity difference between the two points (pi', pf") to the positive electrode capacity difference between the two points (pi0, pf0). Alternatively, the positive electrode scaling factor of the adjusted reference positive electrode profile (Rp") may represent a ratio of the positive electrode SOC difference between the two points (pi', pf") to the positive electrode SOC difference between the two points (pi0, pf0).

The negative electrode scaling factor of the adjusted reference negative electrode profile (Rn') may represent a ratio of the capacity difference between the two points (ni, nf') to the capacity difference between the two points (ni0, nf0). Alternatively, the negative electrode scaling factor of the adjusted reference negative electrode profile (Rn') may represent a ratio of the negative electrode capacity difference between the two points (ni, nf') to the negative electrode capacity difference between the two points (ni0, nf0). Alternatively, the negative electrode scaling factor of the adjusted reference negative electrode profile (Rn') may represent a ratio of the negative electrode SOC difference between the two points (ni, nf') to the negative electrode SOC difference between the two points (ni0, nf0).

Hereinafter, ps may be used as a symbol indicating a positive electrode scaling factor, and ns may be used as a symbol indicating a negative electrode scaling factor.

Meanwhile, as described above, when the positive electrode voltage range of the reference positive electrode profile Rp is divided into a plurality of small voltage sections, the boundary point of two adjacent small voltage sections among the plurality of small voltage sections may be set as a positive electrode participation start point (pi).

For example, if the positive electrode voltage range of the reference positive electrode profile Rp is divided into 100 small voltage ranges, there may be 100 boundary points that can be set as the positive electrode participation start point (pi). Also, if the voltage range greater than or equal to the second set voltage in the reference positive electrode profile Rp is divided into 40 small voltage ranges, there may be 40 boundary points that can be set as the positive electrode participation end point (pf). In this case, at least 4,000 different comparison full-cell profiles may be generated.

Of course, it will be easily understood by those skilled in the art that as the size of the small voltage section decreases, the maximum number of comparison full-cell profiles that can be generated increases, and conversely, as the size of the small voltage section increases, the maximum number of comparison full-cell profiles that can be generated decreases.

The control circuit 130 may identify a minimum value among profile errors of the plurality of comparison full-cell profiles generated as described above, and then obtain the first performance factor group, which is information mapped to the minimum profile error (e.g., at least one of a positive electrode participation start point, a positive electrode participation end point, a negative electrode participation start point, a negative electrode participation end point, a positive electrode scaling factor, and a negative electrode scaling factor), from the memory 131.

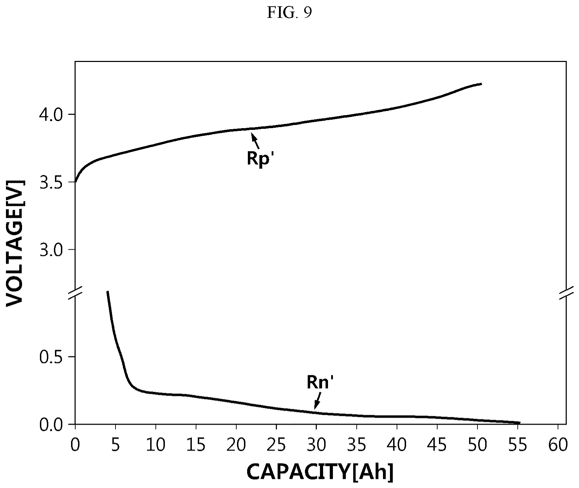

FIGS. 9 to 11 are diagrams referenced to describe another example of a procedure of generating a comparison full-cell profile according to the cell diagnosis logic. For reference, the embodiment shown in FIGS. 9 to 11 is independent from the embodiment shown in FIGS. 6 to 8. Accordingly, terms or reference signs commonly used to describe the embodiment shown in FIGS. 6 to 8 and the embodiment shown in FIGS. 9 to 11 should be understood as being limited to each embodiment.

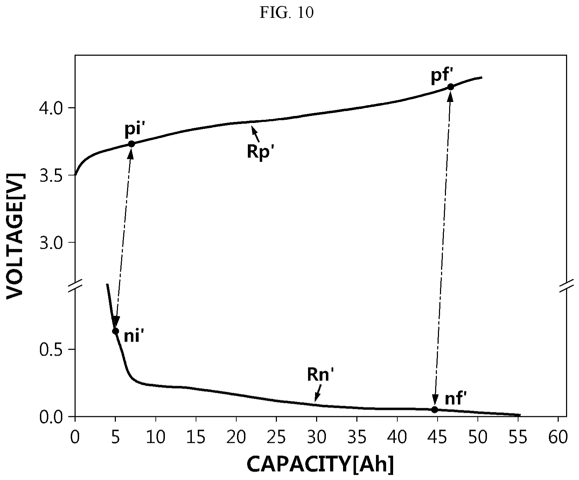

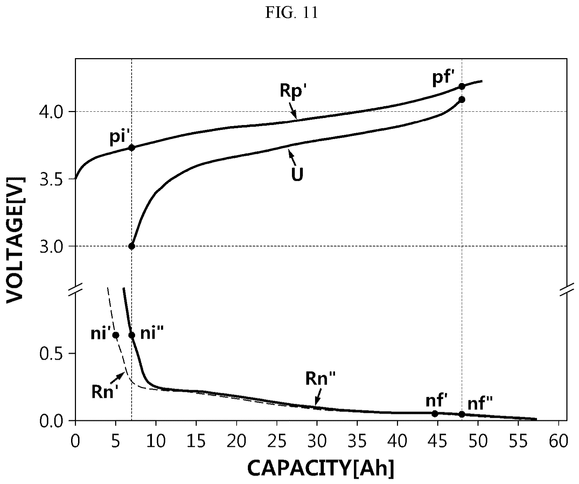

The procedure of generating a comparison full-cell profile U to be explained with reference to FIGS. 9 to 11 may proceed in the order of a fourth routine (see FIG. 9) that performs the capacity scaling, a fifth routine (see FIG. 10) that sets four points (positive electrode participation start point, positive electrode participation end point, negative electrode participation start point, and negative electrode participation end point), and a sixth routine (see FIG. 11) that performs the profile shift. That is, the procedure of generating a comparison full-cell profile according to another embodiment of the present disclosure may include the fourth to sixth routines.

Referring to FIG. 9, the control circuit 130 may generate an adjusted reference positive electrode profile (Rp') and an adjusted reference negative electrode profile (Rn') by applying the positive electrode scaling factor and the negative electrode scaling factor selected from the scaling value range to the reference positive electrode profile Rp and the reference negative electrode profile Rn, respectively.

The scaling value range may be predetermined or may vary depending on the ratio of the size of the capacity range of the estimated full-cell profile E to the size of the capacity range of the second reference full-cell profile R2. As an example, assuming that the positive electrode scaling factor and the negative electrode scaling factor can be selected among the values (i.e., 90%, 90.1%, 90.2%, ... 98.9%, 99%) spaced by 0.1% in the scaling value range (e.g., 90 to 99%), 91 values may be selected as the positive electrode scaling factor and the negative electrode scaling factor, respectively. In this case, according to $91 \times 91 = 8,281$ adjustment levels (combinations of the positive electrode scaling factors and the negative electrode scaling factors), a maximum of 8,281 adjusted profile pairs (Rp', Rn') may be generated. The adjusted profile pair refers to a combination of an adjusted positive electrode profile (Rp') and an adjusted negative electrode profile (Rn').

Referring to FIG. 9, the adjusted reference positive electrode profile (Rp') and the adjusted reference negative electrode profile (Rn') illustrate the result of applying the positive electrode scaling factor and the negative electrode scaling factor, respectively, to the reference positive electrode profile Rp and the reference negative electrode profile Rn.

Since the positive electrode scaling factor and the negative electrode scaling factor are less than 100%, the adjusted reference positive electrode profile (Rp') is obtained by shrinking the reference positive electrode profile Rp along the horizontal axis, and the adjusted reference negative electrode profile (Rn') is also obtained by shrinking the reference negative electrode profile Rn along the horizontal axis. To facilitate understanding, the reference positive electrode profile Rp and the reference negative electrode profile Rn are shown in a form in which the start points of them are respectively fixed and the remaining parts are shrunken to the left along the horizontal axis.

Referring to FIG. 10, the control circuit 130 may determine a positive electrode participation start point (pi'), a positive electrode participation end point (pf'), a negative electrode participation start point (ni'), and a negative electrode participation end point (nf') on the adjusted reference positive electrode profile (Rp') and the adjusted reference negative electrode profile (Rp').

Either the positive electrode participation start point (pi') or the negative electrode participation start point (ni') may depend on the other. Also, either the positive electrode participation end point (pf') or the negative electrode participation end point (nf') may depend on the other. Also, either the positive electrode participation start point (pi') or the positive electrode participation end point (pf') may be set based on the other.

That is, if any one of the positive electrode participation start point (pi'), the positive electrode participation end point (pf'), the negative electrode participation start point (ni'), and the negative electrode participation end point (nf') is set, the remaining three points may be automatically set by the first set voltage, the second set voltage, and/or the size of the capacity range of the estimated full-cell profile E (e.g., 45Ah - 5Ah = 40Ah in FIG. 4).

As an example, the control circuit 130 may divide the positive electrode voltage range from the start point to the end point (or, second set voltage) of the adjusted reference positive electrode profile (Rp') into a plurality of small voltage sections, and then set a boundary point of two adjacent small voltage sections among the plurality of small voltage sections as the positive electrode participation start point (pi'). Next, the control circuit 130 may set a point on the adjusted reference negative electrode profile (Rn') that is smaller than the positive electrode participation start point (pi') by the first set voltage as the negative electrode participation start point (ni').

As another example, the control circuit 130 may divide the negative electrode voltage range from the start point to the end point of the adjusted reference negative electrode profile (Rn') into a plurality of small voltage sections of a predetermined size, and then set a boundary point of two adjacent small voltage sections among the plurality of small voltage sections as the negative electrode participation start point (ni'). Next, the control circuit 130 may search for a point greater than the negative electrode participation start point (ni') by the first set voltage from the adjusted reference positive electrode profile (Rp'), and set the searched point as the positive electrode participation start point (pi').

As still another example, the control circuit 130 may divide the voltage range from the second set voltage to the end point of the adjusted reference positive electrode profile (Rp') into a plurality of small voltage sections of a predetermined size, and then set a boundary point of two adjacent small voltage sections among the plurality of small voltage sections as the positive electrode participation end point (pf'). Next, the control circuit 130 may search for a point smaller than the positive electrode participation end point (pf') by the second set voltage (e.g., 4V) from the adjusted reference negative electrode profile (Rn'), and set the searched point as the negative electrode participation end point (nf').

As still another example, the control circuit 130 may divide the negative electrode voltage range from the start point to the end point of the adjusted second reference negative electrode profile (Rn') into a plurality of small voltage section of a predetermined size, and then set a boundary point of two adjacent small voltage sections among the plurality of small voltage sections as the negative electrode participation end point (nf'). Next, the control circuit 130 may search for a point greater than the negative electrode participation end point (nf') by the second set voltage from the adjusted reference positive electrode profile (Rp'), and set the searched point as the positive electrode participation end point (pf').

If any one of the positive electrode participation start point (pi'), the positive electrode participation end point (pf'), the negative electrode participation start point (ni'), and the negative electrode participation end point (nf') is determined, the control circuit 130 may additionally determine the remaining three points based on the determined point.

For example, if the positive electrode participation start point (pi') is determined first, the control circuit 130 may set a point on the adjusted reference positive electrode profile (Rp') having a capacity value that is larger than the capacity value of the positive electrode participation start point (pi') by the size of the capacity range of the estimated full-cell profile E as the positive electrode participation end point (pf'). In addition, the control circuit 130 may search for a point lower than the positive electrode participation start point (pi') by the first set voltage from the adjusted reference negative electrode profile (Rn'), and set the searched point as the negative electrode participation start point (ni'). In addition, the control circuit 130 may set a point on the adjusted reference negative electrode profile (Rn') having a capacity value greater than the capacity value of the negative electrode participation start point (ni') by the size of the capacity range of the estimated full-cell profile E as the negative electrode participation end point (nf').

As another example, when the positive electrode participation end point (pf') is determined first, the control circuit 130 may set a point on the adjusted reference positive electrode profile (Rp') having a capacity value smaller than the capacity value of the positive electrode participation end point (pf') by the size of the capacity range of the estimated full-cell profile E as the positive electrode participation start point (pi'). In addition, the control circuit 130 may search for a point lower than the positive electrode participation end point (pf') by the second set voltage from the adjusted reference negative electrode profile (Rn'), and set the searched point as the negative electrode participation end point (nf'). In addition, the control circuit 130 may set a point on the adjusted reference negative electrode profile (Rn') having a capacity value smaller than the capacity value of the negative electrode participation end point (nf') by the size of the capacity range of the estimated full-cell profile E as the negative electrode participation start point (ni').

As still another example, when the negative electrode participation start point (ni') is determined, the control circuit 130 may set a point on the adjusted reference negative electrode profile (Rn') having a capacity value larger than the capacity value of the negative electrode participation start point (ni') by the size of the capacity range of the estimated full-cell profile E as the negative electrode participation end point (nf'). In addition, the control circuit 130 may search for a point higher than the negative electrode participation start point (ni') by the first set voltage from the adjusted reference positive electrode profile (Rp'), and set the searched point as the positive electrode participation start point (pi'). In addition, the control circuit 130 may set a point on the adjusted reference positive electrode profile (Rp') having a capacity value greater than the capacity value of the positive electrode participation start point (pi') by the size of the capacity range of the estimated full-cell profile E as the positive electrode participation end point (pf').

As still another example, when the negative electrode participation end point (nf') is determined, the control circuit 130 may set a point on the adjusted reference negative electrode profile (Rn') having a capacity value smaller than the capacity value of the negative electrode participation end point (nf') by the size of the capacity range of the estimated full-cell profile E as the negative electrode participation start point (ni'). In addition, the control circuit 130 may search for a point higher than the negative electrode participation end point (nf') by the second set voltage from the adjusted reference positive electrode profile (Rp'), and set the searched point as the positive electrode participation end point (pf'). In addition, the control circuit 130 may set a point on the adjusted reference positive electrode profile (Rp') having a capacity value smaller than the capacity value of the positive electrode participation end point (pf') by the size of the capacity range of the estimated full-cell profile E as the positive electrode participation start point (pi').

If the positive electrode participation start point (pi'), the positive electrode participation end point (pf'), the negative electrode participation start point (ni') and the negative electrode participation end point (nf') are completely determined based on the pair of positive electrode scaling factor and negative electrode scaling factor, the control circuit 130 may shift at least one of the adjusted reference positive electrode profile (Rp') and the adjusted reference negative electrode profile (Rn') to the left or right along the horizontal axis so that the capacity values of the positive electrode participation start point (pi') and the negative electrode participation start point (ni') match or the capacity values of the positive electrode participation end point (pf') and the negative electrode participation end point (nf') match.

The adjusted reference negative electrode profile (Rn") shown in FIG. 11 is obtained by shifting only the adjusted reference negative electrode profile (Rn') shown in FIG. 10 to the right. Accordingly, the capacity values of the positive electrode participation start point (pi') and the negative electrode participation start point (ni") match each other in the horizontal axis. Relatedly, the capacity difference between the positive electrode participation start point (pi') and the positive electrode participation end point (pf') is equal to the capacity difference between the negative electrode participation start point (ni') and the negative electrode participation end point (nf'). Therefore, if the capacity values of the positive electrode participation start point (pi') and the negative electrode participation start point (ni") match each other in the horizontal axis, the capacity values of the positive electrode participation end point (pf') and the negative electrode participation end point (nf') also match each other in the horizontal axis.

Referring to FIG. 11, the control circuit 130 may generate a comparison full-cell profile U by subtracting the partial profile between two points (pi', pf') of the adjusted reference positive electrode profile (Rp') from the partial profile between two points (ni", nf") of the adjusted reference negative electrode profile (Rn").

The control circuit 130 may calculate an error (profile error) between the comparison full-cell profile U and the estimated full-cell profile E.

The control circuit 130 may map at least two of the adjusted reference positive electrode profile (Rp'), the adjusted reference negative electrode profile (Rn"), the positive electrode participation start point (pi'), the positive electrode participation end point (pf'), the negative electrode participation start point (ni"), the negative electrode participation end point (nf"), the positive electrode scaling factor, the negative electrode scaling factor, the comparison full-cell profile U and the profile error with each other and record the same in the memory 140.

As described above, the control circuit 130 may generate a comparison full-cell profile U corresponding to each pair of the positive electrode scaling factor and the negative electrode scaling factor selected from the scaling value range. Since the pairs of positive electrode scaling factor and negative electrode scaling factor are plural, it is obvious that the comparison profile U will also be generated in plural numbers.

The control circuit 130 may identify a minimum value among profile errors of the plurality of comparison full-cell profiles, and then obtain information mapped to the minimum profile error from the memory 131.

As described above, the control circuit 130 may execute the cell diagnosis logic to generate a comparison full-cell profile with a minimum error from the estimated full-cell profile E based on the reference positive electrode profile Rp and the reference negative electrode profile Rn.

The control circuit 130 may determine a first performance factor group including a performance factor for at least one of a positive electrode participation start point, a positive electrode participation end point, a positive electrode scaling factor, a negative electrode participation start point, a negative electrode participation end point, and a negative electrode scaling factor, which are respectively mapped to a minimum profile error.

Meanwhile, since the first performance factor group is the result of applying the cell diagnosis logic to the estimated full-cell profile E, it may represents the actual charge/discharge performance of the target cell BC more accurately than the result of applying cell diagnosis logic to the first target full-cell profile M.

However, since the overpotential profile OP is related to the reference cell, not the target cell BC, there may still be a considerable difference between the charge/discharge performance indicated by the first performance factor group and the actual charge/discharge performance of the target cell BC.

Therefore, it is desirable to perform a procedure for correcting the first performance factor group to narrow the gap between the charge/discharge performance indicated by the first performance factor group and the actual charge/-

discharge performance, and this may be achieved by a factor correction model, explained later. The correction procedure for the first performance factor group is performed to determine the second performance factor group as a secondary estimation result for the charge/discharge performance of the target cell BC.

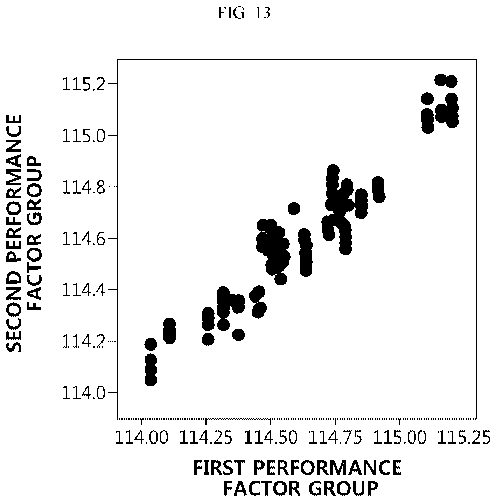

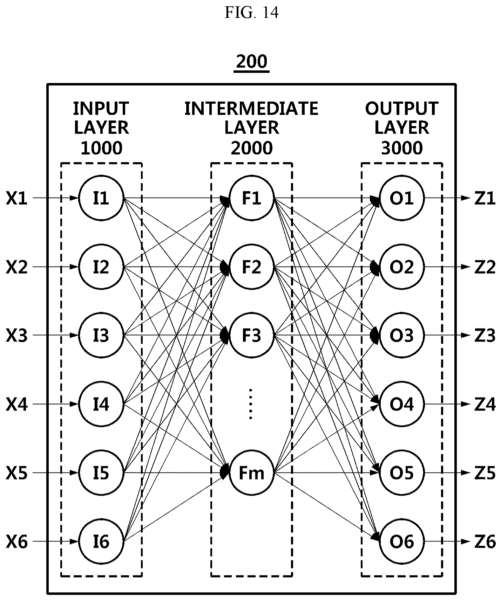

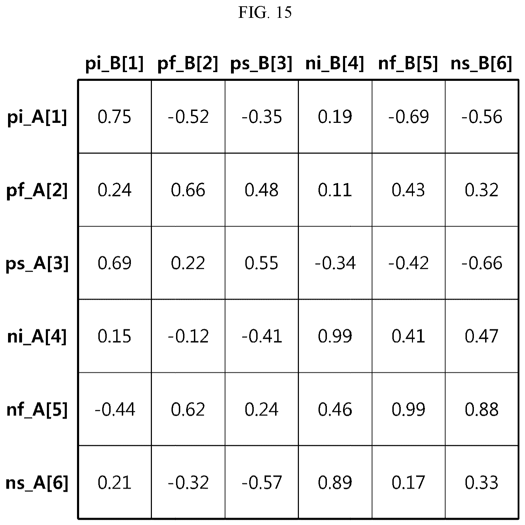

FIG. 12 is a drawing referenced for explaining the function of a factor correction model, FIG. 13 is a drawing referenced for explaining a training data set provided for training the factor correction model, FIG. 14 is a diagram showing an example of a neural network structure of the factor correction model of FIG. 12, and FIG. 15 is a diagram showing an example of a correlation coefficient between performance factors obtained through training the factor correction model.

Referring to FIG. 12, the control circuit 130 may determine the second performance factor group 1220 as the secondary estimation result of the charge/discharge performance of the target cell BC by applying the factor correction model 200 to the first performance factor group 1210 as the primary estimation result of the charge/discharge performance of the target cell BC.

The first performance factor group 1210 may include a performance factor for at least one of the positive electrode participation start point, the negative electrode participation start point, the positive electrode participation end point, the negative electrode participation end point, the positive electrode scaling factor, and the negative electrode scaling factor of the target cell BC, which are determined based on the estimated full-cell profile E.

The second performance factor group 1220 may be a result obtained by correcting the first performance factor group 1210 by the factor correction model 200 so that an error between the charge/discharge performance indicated by the first performance factor group 1210 and the actual charge/discharge performance of the target cell BC is reduced. The second performance factor group 1220 may represent an estimation result for the charge/discharge performance of the target cell BC that would have been determined if the cell diagnosis logic were applied to the second target full-cell profile N. That is, a specific performance factor (e.g., a positive electrode participation end point) of the second performance factor group 1220 may be a specific performance factor of the first performance factor group 1210 that is corrected to be close to the actual specific performance factor of the target cell.

The factor correction model 200 may be a machine learning model trained by a training data set including a pair of first performance factor group and second performance factor group of each of a plurality of test cells.

A plurality of test cells are prepared in advance for the purpose of training the factor correction model 200. At least one of the plurality of test cells may be a new battery cell verified as a good product. Each of the remaining test cells may have a test cell in which at least one of the positive electrode and the negative electrode is forcibly degraded from a new state by charge/discharge cycling different from that of the other test cells.

The first performance factor group of a specific test cell may be obtained in advance by applying the cell diagnosis logic to the estimated test full-cell profile of the corresponding test cell. The estimated test full-cell profile of a specific test cell may be obtained in advance by subtracting the overpotential profile OP from the primary test full-cell profile representing the correspondence between the capacity factor and voltage of the test cell while the first electric stimulation is being applied to the corresponding test cell.

The second performance factor group of a specific test cell may be obtained in advance by applying the cell diagnosis logic to the secondary test full-cell profile of the specific test cell. The secondary test full-cell profile of a specific test cell may represent the correspondence between the capacity factor and voltage of the corresponding test cell while the second electric stimulation is being applied to the corresponding test cell.

In the graph illustrated in FIG. 13, a plurality of data points included in the training data set are marked on the two-dimensional coordinate. The number of data points marked on the graph of FIG. 13 may be equal to the number of test cells.

Each data point is defined by two estimated values for a specific performance factor. That is, the X-axis coordinate of each data point represents a value included in the first performance factor group as an estimated value of the specific performance factor, and the Y-axis coordinate represents a value included in the second performance factor group as another estimated value of the specific performance factor. For convenience of explanation, each of the X-axis and the Y-axis in FIG. 13 is illustrated as representing a positive electrode SOC of the positive electrode participation end point.

Referring to FIG. 13, the data points of the training data set are distributed so as to have a learnable tendency. That is, the correlation between the values included in the first performance factor group as estimated values of a specific performance factor and the values included in the second performance factor group as other estimated values of the specific performance factor may be trained by the factor correction model 200.

The factor correction model 200 may be trained based on the correlation between two estimated values for a specific performance factor, and the correlation information between the two estimated values obtained through learning may be expressed as the correlation coefficient in FIG. 15. This will be explained in detail later.

Referring to FIG. 14, the neural network of factor correction model 200 may include an input layer 1000, an intermediate layer 2000, and an output layer 3000.

In the factor correction model 200, the number of nodes included in each layer, the connections between nodes, the functions of each node included in the intermediate layer 2000, etc. may be determined in advance. In addition, the weights for each connection between nodes may be automatically determined through a machine learning process using the training data set.

The input layer 1000 may include first to sixth input nodes I1 to I6. When i is a natural number less than or equal to 6, the $i^{th}$ input node Ii may be associated with one performance factor of the first performance factor group 1210. In FIG. 14, for convenience of explanation, it is assumed that the first to sixth input nodes I1 to I6 are associated with a positive electrode participation start point, a positive electrode participation end point, a positive electrode scaling factor, a negative electrode participation start point, a negative electrode participation end point, and a negative electrode scaling factor, which may be included in the first performance factor group, respectively.

The $i^{th}$ input node Ii may be provided with the $i^{th}$ input data set Xi, which is performance factor data associated therewith. For example, the first input node I1 may be provided with the first input data set X1. The first input data set X1 may include values (e.g., positive electrode start potential and capacity values) related to the positive electrode participation start points of the plurality of test cells.

The output layer 3000 may include at least one of the first to sixth output nodes O1 to O6. When j is a natural number less than or equal to 6, the $j^{th}$ output node Oj may be associated with any one of a positive electrode participation start point, a positive electrode participation end point, a positive electrode scaling factor, a negative electrode participation start point, a negative electrode participation end point, and a negative electrode scaling factor. In FIG. 14, for convenience of explanation, it is assumed that the first to sixth output nodes O1 to O6 are associated with a positive electrode participation start point, a positive electrode participation end point, a positive electrode scaling factor, a negative electrode participation start point, a negative electrode participation end point, and a negative electrode scaling factor, respectively. The positive electrode participation start point, the positive electrode participation end point, the positive electrode scaling factor, the negative electrode participation start point, the negative electrode participation end point, and the negative electrode scaling factor may be referred to as the first to sixth performance factors, in that order.

When the first to sixth input data sets X1 to X6 are input to the first to sixth input nodes I1 to I6, the $j^{th}$ output data set Zj may be output from the $j^{th}$ output node Oj. For example, when the first output node O1 is associated with a positive electrode participation start point, the third output data set Z3 may include the values of the first input data set X1 with corrections.

FIG. 14 illustrates that the input layer 1000 includes the first to sixth input nodes I1 to I6 and the output input layer 2000 includes the first to sixth output nodes O1 to O6, but this is only an example. That is, it is sufficient for the input layer 1000 to include at least one of the first to sixth input nodes I1 to I6, and it is also sufficient for the output layer 3000 to include at least one of the first to sixth output nodes O1 to O6. For example, when all of the first to sixth input data sets X1 to X6 are provided to the input layer 1000, the output layer 3000 may output only one of the first to sixth output data sets Z1 to Z6.

Which output data set among the first to sixth output data sets Z1 to Z6 will be output by the factor correction model 200 may be determined by the connections between nodes, the weights for each connection between nodes, the functions of each node included in the intermediate layer 2000, etc., and is not particularly limited.

The intermediate layer 2000 may include first to $m^{th}$ intermediate nodes F1 to Fm (m is a natural number greater than or equal to 2). When k is a natural number less than or equal to m, the $k^{th}$ intermediate node Fk may be connected to at least one of the first to sixth input nodes I1 to I6 and at least one of the first to sixth output nodes O1 to O6. The $k^{th}$ intermediate node Fk may have a form of a function determined through a learning process, and may transmit an estimated value calculated based on the input value from each input node connected thereto to each output node connected thereto. The $j^{th}$ output node Oj may output an estimated value equal to the sum of the estimated values received from each intermediate node connected thereto as a correction result of the first performance factor group.

The function of the $k^{th}$ intermediate node Fk may be generated based on the correlation coefficient between the performance factor associated with each node of the input layer 1000 connected to the $k^{th}$ intermediate node Fk and the performance factor associated with each node of the output layer 3000 connected to the $k^{th}$ intermediate node Fk. For reference, the correlation coefficient is a real number between -1 and +1, and a correlation coefficient closer to -1 indicates a negative correlation between two factors, and a correlation coefficient closer to +1 indicates a positive correlation between two factors.

The function for each intermediate node of the intermediate layer 2000 may be a weighted average function. In this case, a correlation coefficient indicating the degree of correlation between the estimated values of the first to sixth performance factors included in the first performance factor group and the estimated values of at least one of the first to sixth performance factors included in the second performance factor group may be used as a weight of the function for each intermediate node of the intermediate layer 2000.

Therefore, the factor correction model 200 includes at least one of the first to sixth machine learning models. The first to sixth machine learning models may be models that provide secondary estimation results for the first to sixth performance factors, in that order.

When the target cell BC is in the MOL state, the control circuit 130 may determine at least one degradation parameter based on the second performance factor group. Table 1 below summarizes the degradation parameters and formulas that may be used to determine each degradation parameter. For reference, the second performance factor group when the target cell BC was in a new state may already be recorded in the memory 131.

Table 1

| Degradation parameter | Formula |
|---|---|
| $P_{SOH}$ | $1 - \dfrac{pf_{BOL} - pf_{MOL}}{pf_{BOL} - pi_{BOL}}$ , $\dfrac{pf_{MOL} - pi_{BOL}}{pf_{BOL} - pi_{BOL}}$ , $1 - \dfrac{pf_{BOL} - pf_{MOL}}{nf_{BOL} - ni_{BOL}}$ , $\dfrac{ps_{MOL}}{ps_{BOL}}$ |
| $N_{SOH}$ | $\dfrac{ns_{MOL}}{ns_{BOL}}$ |
| $L_{SOH}$ | $1 - \dfrac{pi_{MOL} - pi_{BOL}}{pf_{BOL} - pi_{BOL}}$ , $\dfrac{pf_{BOL} - pi_{MOL}}{pf_{BOL} - pi_{BOL}}$ , $1 - \dfrac{pi_{MOL} - pi_{BOL}}{nf_{BOL} - ni_{BOL}}$ |
| $F_{SOH}$ | $\dfrac{pf_{MOL} - pi_{MOL}}{pf_{BOL} - pi_{BOL}}$ , $\dfrac{nf_{MOL} - ni_{MOL}}{nf_{BOL} - ni_{BOL}}$ |
| $P_{LOSS}$ | $\dfrac{pf_{BOL} - pf_{MOL}}{pf_{BOL} - pi_{BOL}}$ , $\dfrac{pf_{BOL} - pf_{MOL}}{nf_{BOL} - ni_{BOL}}$ , $1 - \dfrac{ps_{MOL}}{ps_{BOL}}$ |
| $N_{LOSS}$ | $1 - \dfrac{ns_{MOL}}{ns_{BOL}}$ |
| $L_{LOSS}$ | $\dfrac{pi_{MOL} - pi_{BOL}}{pf_{BOL} - pi_{BOL}}$ , $\dfrac{pi_{MOL} - pi_{BOL}}{nf_{BOL} - ni_{BOL}}$ |
| $F_{LOSS}$ | $1 - \dfrac{pf_{MOL} - pi_{MOL}}{pf_{BOL} - pi_{BOL}}$ , $1 - \dfrac{nf_{MOL} - ni_{MOL}}{nf_{BOL} - ni_{BOL}}$ , $\dfrac{(pf_{BOL} - pi_{BOL}) - (pf_{MOL} - pi_{MOL})}{nf_{BOL} - ni_{BOL}}$ |
| $P_{loading\_MOL}$ | $ps_{MOL} \times P_{loading\_ref}$ |
| $N_{loading\_MOL}$ | $ns_{MOL} \times N_{loading\_ref}$ |
| N/P$_{\_MOL}$ | $\dfrac{N_{loading\_MOL}}{P_{loading\_MOL}}$ , $\dfrac{ns_{MOL} \times Q_{N\_ref}}{ps_{MOL} \times Q_{P\_ref}}$ |

Each of the variables listed in Table 1 is a diagnostic factor that may be included in the second performance factor group described above. The definitions of the degradation parameters and variables in Table 1 may be as follows.

<Degradation parameters >

PSOH: positive electrode SOH (State Of Health) of the target cell BC
NSOH: negative electrode SOH of the target cell BC
LSOH: available lithium SOH of the target cell BC
FSOH: full-cell SOH of the target cell BC
PLOSS: positive electrode loss rate of the target cell BC
NLOSS: negative electrode loss rate of the target cell BC
LLOSS: available lithium loss rate of the target cell BC
FLOSS: full-cell loss rate of the target cell BC
$P_{loading\_MOL}$: positive electrode loading amount of the target cell BC
$N_{loading\_MOL}$: negative electrode loading amount of the target cell BC
N/P$_{\_MOL}$: NP ratio of the target cell BC

As any battery cell deteriorates, at least one of the total positive electrode capacity, the total negative electrode capacity, the available lithium content, and the total full-cell capacity of the battery cell may gradually decrease from the value at the BOL (Beginning Of Life) state. The total full-cell capacity may represent the capacity difference between both end points of the full-cell profile. For example, the total full-cell capacity may mean a full charge capacity (FCC). The available lithium content may represent the total amount of lithium that may contribute to charging and discharging of the battery cell. $P_{SOH}$ may represent the maintenance rate of the total positive electrode capacity. $N_{SOH}$ may represent the maintenance rate of the total negative electrode capacity. $L_{SOH}$ may represent the maintenance rate of the available lithium content. $F_{SOH}$ may represent the maintenance rate of the total full-cell capacity.

The sum of $P_{SOH}$ and $P_{LOSS}$, the sum of $N_{SOH}$ and $N_{LOSS}$, the sum of $L_{SOH}$ and $L_{LOSS}$, and the sum of $F_{SOH}$ and $F_{LOSS}$ may each be equal to 1. $F_{LOSS}$ may be equal to the sum of $P_{LOSS}$ and $L_{LOSS}$.

The positive electrode loading amount of any battery cell represents the amount of positive electrode active material (or available capacity) per unit area of the positive electrode of the battery cell. The negative electrode loading amount of any battery cell represents the amount of negative electrode active material (or available capacity) per unit area of the negative electrode of the battery cell. The unit of the loading amount may be mAh/cm$^2$ or mg/cm$^2$. In Table 1, $P_{loading\_ref}$ represents the reference positive electrode loading amount, and $N_{loading\_ref}$ represents the reference negative electrode loading amount. The reference positive electrode loading amount is a predetermined value representing the amount of positive electrode active material (or available capacity) per unit area of the positive electrode of the reference cell. The reference positive electrode loading amount may be a value obtained by dividing the reference positive electrode capacity ($Q_{P\_ref}$) by the reference positive electrode area. Here, the reference positive electrode capacity may be a value preset as the total positive electrode capacity of the reference cell. The reference positive electrode area may be a value preset as the area of the positive electrode of the reference cell. The reference negative electrode loading amount is a predetermined value representing the amount of negative electrode active material (or available capacity) per unit area of the negative electrode of the reference cell. The reference negative electrode loading amount may be a value obtained by dividing the reference negative electrode capacity ($Q_{N\_ref}$) by the reference negative electrode area. Here, the reference negative electrode capacity may be a value preset as the total negative electrode capacity of the reference cell. The reference negative electrode area may be a value preset as the area of the negative electrode of the reference cell.

<Variables>

$pi_{BOL}$: positive electrode capacity (positive electrode SOC) of the positive electrode participation start point when the target cell BC is in the BOL state

$pi_{MOL}$: positive electrode capacity (positive electrode SOC) of the current positive electrode participation start point (e.g., pi' shown in FIG. 8) of the target cell BC

$pf_{BOL}$: positive electrode capacity (positive electrode SOC) of the positive electrode participation end point when the target cell BC is in the BOL state

$pf_{MOL}$: positive electrode capacity (positive electrode SOC) of the current positive electrode participation end point (e.g., pf" shown in FIG. 8) of the target cell BC

$ni_{BOL}$: negative electrode capacity (negative electrode SOC) at the negative electrode participation start point when the target cell BC is in the BOL state

$ni_{MOL}$: negative electrode capacity (negative electrode SOC) of the current negative electrode participation start point (e.g., ni shown in FIG. 8) of the target cell BC

$nf_{BOL}$: negative electrode capacity (negative electrode SOC) of the negative electrode participation end point when the target cell BC is in the BOL state

$nf_{MOL}$: negative electrode capacity (negative electrode SOC) of the current negative electrode participation end point (e.g., nf' shown in FIG. 8) of the target cell BC

$ps_{BOL}$: positive electrode scaling factor when the target cell BC is in the BOL state

$ps_{MOL}$: current positive electrode scaling factor of the target cell BC

$ns_{BOL}$: negative electrode scaling factor when the target cell BC is in the BOL state

$ns_{MOL}$: current negative electrode scaling factor of the target cell BC

The process of determining the second performance factor group may be repeated periodically or aperiodically throughout the life of the target cell BC.

FIG. 15 shows an example of correlation information between the first performance factor group and the second performance factor group obtained through learning for the factor correction model 200 in a matrix form.

The matrix illustrated in FIG. 15 is a 6 × 6 matrix. The six rows represent the first to sixth performance factors of the first performance factor group provided as a training data set, in that order. The six columns represent the first to sixth performance factors of the second performance factor group provided as a training data set, in that order. In FIG. 15, pi_A [1], pf_A[2], ps_A[3], ni_A[4], nf_A[5], and ns_A[6] represent the positive electrode participation start point, the positive electrode participation end point, the positive electrode scaling factor, the negative electrode participation start point, the negative electrode participation end point, and the negative electrode scaling factor, which are included in the first performance factor group of the training data set, in that order. Also, pi_B[1], pf_B[2], ps_B[3], ni_B[4], nf_B[5] and ns_B[6] represent the positive electrode participation start point, the positive electrode participation end point, the positive electrode scaling factor, the negative electrode participation start point, the negative electrode participation end point and the negative electrode scaling factor, which are included in the second performance factor group of the training data set, respectively.

When p and q are natural numbers less than or equal to 6, the values of the p$^{th}$ row (pi_A[p]) and the q$^{th}$ column (pi_B[q]) represent the correlation coefficient between the p$^{th}$ performance factor included in the first performance factor group and the q$^{th}$ performance factor included in the second performance factor group.

For example, the correlation coefficient between the first performance factor (pi_A[1]) in the first row and the second performance factor (pf_B[2]) in the second column is -0.52. As another example, the correlation coefficient between the fifth performance factor (nf_A[5]) in the fifth row and the fourth performance factor (ni_B[4]) in the fourth column is 0.46.

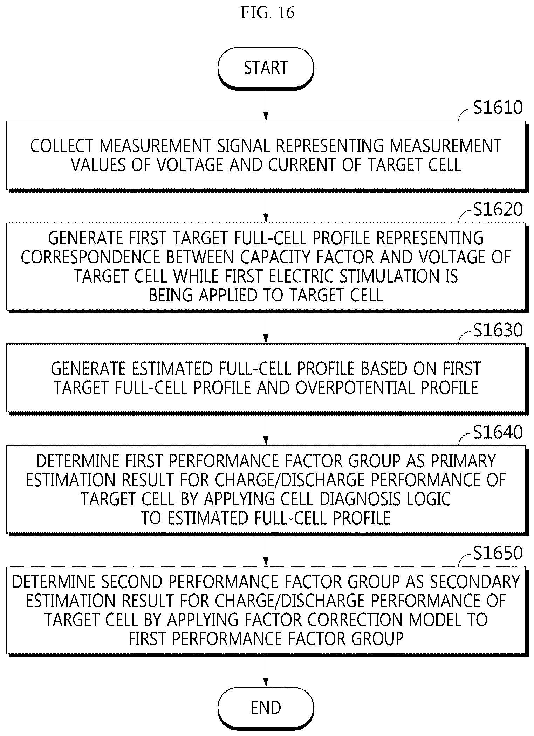

FIG. 16 is a flowchart for schematically illustrating a battery diagnosis method according to another embodiment of the present disclosure. The method of FIG. 16 may be executed by the battery diagnosis apparatus 100.

Referring to FIGS. 1 to 16, in Step S1610, the control circuit 130 collects a measurement signal representing the measurement values of the voltage and current of the target cell BC, which is a battery cell to be diagnosed, from the sensing unit 110.

In Step S1620, the control circuit 130 generates a first target full-cell profile M representing a correspondence between the capacity factor and the voltage of the target cell BC while the first electric stimulation is being applied to the target cell BC, based on the measurement signal collected in Step S1610.

Steps S1610 and S1620 may be replaced with a procedure in which the data obtaining unit obtains the first target full-cell profile M directly or from the outside.

In Step S1630, the control circuit 130 generates an estimated full-cell profile E based on the first target full-cell profile M and the overpotential profile OP.

In Step S1640, the control circuit 130 applies a cell diagnosis logic to the estimated full-cell profile E to determine a first performance factor group 1210 as a primary estimation result for the charge/discharge performance of the target cell BC.

In Step S1650, the control circuit 130 determines a second performance factor group 1220 as a secondary estimation result for the charge/discharge performance of the target cell BC by applying the factor correction model 200 to the first performance factor group 1210. Here, the second performance factor group includes an estimation result of the positive electrode participation end point of the target cell BC, which may be determined if the cell diagnosis logic is applied to the second target full-cell profile N instead of the estimated full-cell profile E.

The second target full-cell profile N represents the correspondence between the capacity factor and voltage of the target cell BC while the second electric stimulation, which is different from the first electric stimulation, is being applied to the target cell BC. The second target full-cell profile N is not obtained by actually applying the second electric stimulation to the target cell BC. That is, the second target full-cell profile N represents the correspondence between the capacity factor and voltage of the target cell BC, which is expected to be obtained if the second electric stimulation was applied to the target cell BC instead of the first electric stimulation.

The control circuit 130 may limit at least one of an allowable voltage range, an allowable SOC range, and an allowable charge/discharge current for the target cell BC based on at least one degradation parameter. The memory 131 may pre-store relationship data indicating the correspondence between the at least one limitation item (i.e., the allowable voltage range, the allowable SOC range, and/or the allowable charge/discharge current) and the at least one degradation parameter. For example, as the increase amount of a specific type of degradation parameter (e.g., $P_{LOSS}$, $N_{LOSS}$, $L_{LOSS}$, $F_{LOSS}$) from the BOL state is larger and/or as the decrease amount of another type of degradation parameter (e.g., $P_{SOH}$, $N_{SOH}$, $L_{SOH}$, $F_{SOH}$) from the BOL state is larger, the limitation amount for the allowable voltage range, the allowable SOC range, and/or the allowable charge/discharge current may be greater.

The embodiments of the present disclosure described hereinabove are not implemented only through the apparatus and method, and may be implemented through programs that perform functions corresponding to the configurations of the embodiments of the present disclosure or recording media having the programs recorded thereon, and such implementation may be easily achieved by those skilled in the art from the disclosure of the embodiments previously described.

While the present disclosure has been hereinabove described with regard to a limited number of embodiments and drawings, the present disclosure is not limited thereto and it is obvious to those skilled in the art that various modifications and changes may be made thereto within the technical aspects of the present disclosure and the equivalent scope of the appended claims.

Additionally, as many substitutions, modifications and changes may be made to the present disclosure described hereinabove by those skilled in the art without departing from the technical aspects of the present disclosure, the present disclosure is not limited by the above-described embodiments and the accompanying drawings, and some or all of the embodiments may be selectively combined to allow various modifications.

**Claims**

1. A battery diagnosis apparatus comprising:

    a data obtaining unit configured to obtain a first target full-cell profile representing a correspondence between a capacity factor and a voltage of a target cell while a first electric stimulation is being applied to the target cell, which is a battery cell to be diagnosed; and
    a control circuit configured to generate an estimated full-cell profile based on the first target full-cell profile and an overpotential profile,
    wherein the control circuit is configured to:

       determine a first performance factor group as a primary estimation result for charge/discharge performance of the target cell by applying a cell diagnosis logic to the estimated full-cell profile, and
       determine a second performance factor group as a secondary estimation result for the charge/discharge performance of the target cell by applying a factor correction model to the first performance factor group, wherein the second performance factor group includes an estimation result of a positive electrode participation end point of the target cell, which is determinable by applying the cell diagnosis logic to a second target full-cell profile representing a correspondence between the capacity factor and the voltage of the target cell while a second electric stimulation, which is different from the first electric stimulation, is being applied.

2. The battery diagnosis apparatus according to claim 1, wherein the first electric stimulation is an electric stimulation that induces an overpotential exceeding an allowable level in the target cell, and
wherein the second electric stimulation is an electric stimulation that induces an overpotential less than the allowable level in the target cell.

3. The battery diagnosis apparatus according to claim 1, wherein the first electric stimulation is charging using a first current rate, and
wherein the second electric stimulation is charging using a second current rate, which is less than the first current rate.

4. The battery diagnosis apparatus according to claim 1, wherein the first electric stimulation is discharge using a first current rate, and
wherein the second electric stimulation is discharge using a second current rate, which is less than the first current rate.

5. The battery diagnosis apparatus according to claim 1, wherein the overpotential profile represents a difference between a first reference full-cell profile and a second reference full-cell profile,

    wherein the first reference full-cell profile represents a correspondence between a capacity factor and a voltage of a reference cell while the first electric stimulation is being applied to the reference cell, which is a battery cell that is verified as normal, and
    wherein the second reference full-cell profile represents a correspondence between the capacity factor and the voltage of the reference cell while the second electric stimulation is being applied to the reference cell.

6. The battery diagnosis apparatus according to claim 1, wherein the control circuit is configured to generate the estimated full-cell profile by subtracting the overpotential profile from the first target full-cell profile.

7. The battery diagnosis apparatus according to claim 1, wherein the first performance factor group includes at least one of followings as a performance factor:

    a positive electrode participation start point representing a positive electrode voltage and a positive electrode capacity when the voltage of the target cell matches a first set voltage;

a positive electrode participation end point representing a positive electrode voltage and a positive electrode capacity when the voltage of the target cell matches a second set voltage;

a positive electrode scaling factor representing a ratio of capacity differences of the positive electrode participation start point and the positive electrode participation end point with respect to a reference positive electrode capacity;

a negative electrode participation start point representing a negative electrode voltage and a negative electrode capacity when the voltage of the target cell matches the first set voltage;

a negative electrode participation end point representing a negative electrode voltage and a negative electrode capacity when the voltage of the target cell matches the second set voltage; and

a negative electrode scaling factor representing a ratio of capacity differences of the negative electrode participation start point and the negative electrode participation end point with respect to a reference negative electrode capacity.

8. The battery diagnosis apparatus according to claim 1, wherein the factor correction model is a machine learning model trained by a training data set that includes a pair of first performance factor group and second performance factor group of each of a plurality of test cells with different charge/discharge performances.

9. The battery diagnosis apparatus according to claim 8, wherein the first performance factor group of each of the plurality of test cells is obtained by applying the cell diagnosis logic to each of a plurality of estimated test full-cell profiles,

wherein the plurality of estimated test full-cell profiles are obtained by subtracting the overpotential profile from each of a plurality of primary test full-cell profiles representing a correspondence between the capacity factor and the voltage of each of the plurality of test cells while the first electric stimulation is being applied to each of the plurality of test cells,

wherein the second performance factor group of each of the plurality of test cells is obtained by applying the cell diagnosis logic to a plurality of secondary test full-cell profiles, and

wherein the plurality of secondary test full-cell profiles represent a correspondence between the capacity factor and the voltage of each of the plurality of test cells while the second electric stimulation is being applied to each to the plurality of test cells.

10. A battery pack comprising the battery diagnosis apparatus according to any one of claims 1 to 9.

11. An electric vehicle comprising the battery pack according to claim 10.

12. A battery diagnosis method comprising:

obtaining a first target full-cell profile representing a correspondence between a capacity factor and a voltage of a target cell while a first electric stimulation is being applied to the target cell, which is a battery cell to be diagnosed;

generating an estimated full-cell profile based on the first target full-cell profile and an overpotential profile;

determining a first performance factor group as a primary estimation result for charge/discharge performance of the target cell by applying a cell diagnosis logic to the estimated full-cell profile; and

determining a second performance factor group as a secondary estimation result for the charge/discharge performance of the target cell by applying a factor correction model to the first performance factor group,

wherein the second performance factor group includes an estimation result of a positive electrode participation end point of the target cell, which is determinable by applying the cell diagnosis logic to a second target full-cell profile instead of the estimated full-cell profile, wherein the second target full-cell profile represents a correspondence between the capacity factor and the voltage of the target cell while a second electric stimulation, which is different from the first electric stimulation, is being applied.

13. The battery diagnosis method according to claim 12, wherein the step of generating an estimated full-cell profile is generating the estimated full-cell profile by subtracting the overpotential profile from the first target full-cell profile.

14. The battery diagnosis method according to claim 12, wherein the factor correction model is a machine learning model trained by a training data set that includes a pair of first performance factor group and second performance factor group of each of a plurality of test cells with different charge/discharge performances.

15. The battery diagnosis method according to claim 14, wherein the first performance factor group of each of the plurality of test cells is obtained by applying the cell diagnosis logic to each of a plurality of estimated test full-cell profiles,

wherein the plurality of estimated test full-cell profiles are obtained by subtracting the overpotential profile from each of a plurality of primary test full-cell profiles representing a correspondence between the capacity factor and the voltage of each of the plurality of test cells while the first electric stimulation is being applied to each of the plurality of test cells,

wherein the second performance factor group of each of the plurality of test cells is obtained by applying the cell diagnosis logic to a plurality of secondary test full-cell profiles, and

wherein the plurality of secondary test full-cell profiles represent a correspondence between the capacity factor and the voltage of each of the plurality of test cells while the second electric stimulation is being applied to each to the plurality of test cells.

FIG. 1

FIG. 2

FIG. 3

FIG. 4

FIG. 5

FIG. 6

FIG. 7

FIG. 8

FIG. 9

FIG. 10

FIG. 11

FIG. 12

FIRST PERFORMANCE FACTOR GROUP — 1210

POSITIVE ELECTRODE PARTICIPATION START POINT
NEGATIVE ELECTRODE PARTICIPATION START POINT
POSITIVE ELECTRODE PARTICIPATION END POINT
NEGATIVE ELECTRODE PARTICIPATION END POINT
POSITIVE ELECTRODE SCALING FACTOR
NEGATIVE ELECTRODE SCALING FACTOR

FACTOR CORRECTION MODEL — 200

MACHINE LEARNING

SECOND PERFORMANCE FACTOR GROUP — 1220

POSITIVE ELECTRODE PARTICIPATION START POINT
NEGATIVE ELECTRODE PARTICIPATION START POINT
POSITIVE ELECTRODE PARTICIPATION END POINT
NEGATIVE ELECTRODE PARTICIPATION END POINT
POSITIVE ELECTRODE SCALING FACTOR
NEGATIVE ELECTRODE SCALING FACTOR

FIG. 13:

FIG. 14

**200**

FIG. 15

|  | pi_B[1] | pf_B[2] | ps_B[3] | ni_B[4] | nf_B[5] | ns_B[6] |
|---|---|---|---|---|---|---|
| **pi_A[1]** | 0.75 | -0.52 | -0.35 | 0.19 | -0.69 | -0.56 |
| **pf_A[2]** | 0.24 | 0.66 | 0.48 | 0.11 | 0.43 | 0.32 |
| **ps_A[3]** | 0.69 | 0.22 | 0.55 | -0.34 | -0.42 | -0.66 |
| **ni_A[4]** | 0.15 | -0.12 | -0.41 | 0.99 | 0.41 | 0.47 |
| **nf_A[5]** | -0.44 | 0.62 | 0.24 | 0.46 | 0.99 | 0.88 |
| **ns_A[6]** | 0.21 | -0.32 | -0.57 | 0.89 | 0.17 | 0.33 |

FIG. 16

START

⌐S1610

COLLECT MEASUREMENT SIGNAL REPRESENTING MEASUREMENT VALUES OF VOLTAGE AND CURRENT OF TARGET CELL

⌐S1620

GENERATE FIRST TARGET FULL-CELL PROFILE REPRESENTING CORRESPONDENCE BETWEEN CAPACITY FACTOR AND VOLTAGE OF TARGET CELL WHILE FIRST ELECTRIC STIMULATION IS BEING APPLIED TO TARGET CELL

⌐S1630

GENERATE ESTIMATED FULL-CELL PROFILE BASED ON FIRST TARGET FULL-CELL PROFILE AND OVERPOTENTIAL PROFILE

⌐S1640

DETERMINE FIRST PERFORMANCE FACTOR GROUP AS PRIMARY ESTIMATION RESULT FOR CHARGE/DISCHARGE PERFORMANCE OF TARGET CELL BY APPLYING CELL DIAGNOSIS LOGIC TO ESTIMATED FULL-CELL PROFILE

⌐S1650

DETERMINE SECOND PERFORMANCE FACTOR GROUP AS SECONDARY ESTIMATION RESULT FOR CHARGE/DISCHARGE PERFORMANCE OF TARGET CELL BY APPLYING FACTOR CORRECTION MODEL TO FIRST PERFORMANCE FACTOR GROUP

END

## INTERNATIONAL SEARCH REPORT

| International application No. |
|---|
| **PCT/KR2024/016664** |

| A. | CLASSIFICATION OF SUBJECT MATTER |
|---|---|

**G01R 31/367**(2019.01)i; **G01R 31/374**(2019.01)i; **G01R 31/3842**(2019.01)i; **G01R 31/396**(2019.01)i; **G01R 19/165**(2006.01)i; **G01R 19/10**(2006.01)i; **G01R 19/00**(2006.01)i; **G06N 20/00**(2019.01)i; **B60L 58/12**(2019.01)i

According to International Patent Classification (IPC) or to both national classification and IPC

| B. | FIELDS SEARCHED |
|---|---|

Minimum documentation searched (classification system followed by classification symbols)

G01R 31/367(2019.01); G01R 31/36(2006.01); G01R 31/374(2019.01); G01R 31/3842(2019.01); G01R 31/392(2019.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 용량(capacity), 전압(voltage), 프로파일(profile), 보정(compensat e), 머신 러닝(machine learning)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2023-0036707 A (SAMSUNG ELECTRONICS CO., LTD.) 15 March 2023 (2023-03-15)<br>See paragraphs [0033]-[0121], claims 1-5 and figures 1-2 and 9-10. | 1-15 |
| A | KR 10-2018-0049590 A (KOREA ELECTROTECHNOLOGY RESEARCH INSTITUTE) 11 May 2018 (2018-05-11)<br>See paragraphs [0018]-[0022] and figure 1. | 1-15 |
| A | KR 10-2258833 B1 (LG ENERGY SOLUTION, LTD.) 31 May 2021 (2021-05-31)<br>See paragraphs [0067]-[0220]. | 1-15 |
| A | KR 10-2023-0052759 A (LG ENERGY SOLUTION, LTD.) 20 April 2023 (2023-04-20)<br>See claims 1-12 and figure 1. | 1-15 |
| A | CN 116774084 A (ABB SWITZERLAND CO., LTD.) 19 September 2023 (2023-09-19)<br>See claims 1-12. | 1-15 |

☐ Further documents are listed in the continuation of Box C.      ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **21 February 2025** | **24 February 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/016664**

| Patent document cited in search report | | | Publication date (day/month/year) | Patent family member(s) | | | Publication date (day/month/year) |
|---|---|---|---|---|---|---|---|
| KR | 10-2023-0036707 | A | 15 March 2023 | CN | 115774212 | A | 10 March 2023 |
| | | | | EP | 4148443 | A1 | 15 March 2023 |
| | | | | EP | 4148443 | B1 | 20 March 2024 |
| | | | | US | 2023-0073869 | A1 | 09 March 2023 |
| KR | 10-2018-0049590 | A | 11 May 2018 | | None | | |
| KR | 10-2258833 | B1 | 31 May 2021 | CN | 110168389 | A | 23 August 2019 |
| | | | | CN | 110168389 | B | 13 July 2021 |
| | | | | EP | 3598156 | A1 | 22 January 2020 |
| | | | | EP | 3598156 | A4 | 27 May 2020 |
| | | | | EP | 3598156 | B1 | 26 April 2023 |
| | | | | JP | 2020-507067 | A | 05 March 2020 |
| | | | | JP | 6880424 | B2 | 02 June 2021 |
| | | | | KR | 10-2019-0036982 | A | 05 April 2019 |
| | | | | US | 11187756 | B2 | 30 November 2021 |
| | | | | US | 2020-0018799 | A1 | 16 January 2020 |
| | | | | WO | 2019-066294 | A1 | 04 April 2019 |
| KR | 10-2023-0052759 | A | 20 April 2023 | CN | 117355759 | A | 05 January 2024 |
| | | | | EP | 4354163 | A1 | 17 April 2024 |
| | | | | EP | 4354163 | A4 | 15 January 2025 |
| | | | | JP | 2024-518954 | A | 08 May 2024 |
| | | | | US | 2024-0288500 | A1 | 29 August 2024 |
| | | | | WO | 2023-063599 | A1 | 20 April 2023 |
| CN | 116774084 | A | 19 September 2023 | CA | 3192566 | A1 | 18 September 2023 |
| | | | | EP | 4246162 | A1 | 20 September 2023 |
| | | | | EP | 4246162 | B1 | 10 July 2024 |
| | | | | US | 2023-0314528 | A1 | 05 October 2023 |

Form PCT/ISA/210 (patent family annex) (July 2022)

**EP 4 667 954 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230165462